(19)

Europäisches
Patentamt
European
Patent Office
Office européen
des brevets

(11) **EP 1 638 181 B1**

(12) **EUROPEAN PATENT SPECIFICATION**

(45) Date of publication and mention
of the grant of the patent:
**15.08.2012 Bulletin 2012/33**

(51) Int Cl.:
**H02H 1/00** (2006.01)

(21) Application number: **05254787.4**

(22) Date of filing: **29.07.2005**

(54) **Apparatus and method for detecting arc faults**

Vorrichtung und Verfahren zur Erkennung von Lichtbögen

Dispositif et procédé pour la détection de défauts d'arc

(84) Designated Contracting States:
**DE FR GB**

(30) Priority: **09.09.2004 US 937487**
**09.09.2004 US 937486**

(43) Date of publication of application:
**22.03.2006 Bulletin 2006/12**

(73) Proprietor: **Sensata Technologies Massachusetts, Inc.**
**Attleboro MA 02703 (US)**

(72) Inventors:
• **Pellon, Christian V.**
**Norton**
**Massachusetts 02766 (US)**
• **Rabiner, Mark D.**
**Cambridge**
**Massachusetts 02140 (US)**
• **Nicolls, Christopher A.**
**Cumberland**
**Rhode Island 02864 (US)**
• **Zanelli, Robert**
**Rehoboth**
**Massachusetts 02769 (US)**
• **Fontaine, Lucien**
**Lincoln**
**Rhode Island 02865 (US)**
• **Edmunds, Lynwald**
**Mansfield**
**Massachusetts 02048 (US)**
• **Parker, Michael**
**Camarillo**
**California 93010 (US)**

• **Kawate, Keith W.**
**Attleboro Falls**
**Massachusetts 02763 (US)**
• **Mayer, Roger D.**
**Attleboro**
**Massachusetts 02703 (US)**
• **Lavado, Michael J.**
**Griswold**
**Connecticut 06351 (US)**
• **Ting, Jeffrey B.**
**New York**
**New York 10010 (US)**

(74) Representative: **Legg, Cyrus James Grahame et al**
**Abel & Imray**
**20 Red Lion Street**
**London WC1R 4PQ (GB)**

(56) References cited:
**EP-A- 1 429 437** **US-A1- 2004 066 593**
**US-A1- 2004 095 695** **US-B1- 6 532 424**

• **BENNER C L ET AL: "PRACTICAL HIGH-IMPEDANCE FAULT DETECTION ON DISTRIBUTION FEEDERS" IEEE TRANSACTIONS ON INDUSTRY APPLICATIONS, IEEE SERVICE CENTER, PISCATAWAY, NJ, US, vol. 33, no. 3, May 1997 (1997-05), pages 635-640, XP000724703 ISSN: 0093-9994**
• **GREGORY G D ET AL: "The arc-fault circuit interrupter, an emerging product" INDUSTRIAL AND COMMERCIAL POWER SYSTEMS TECHNICAL CONFERENCE, 1998 IEEE EDMONTON, ALTA., CANADA 3-8 MAY 1998, NEW YORK, NY, USA,IEEE, US, 3 May 1998 (1998-05-03), pages 48-55, XP010291815 ISBN: 0-7803-4509-6**

EP 1 638 181 B1

**Description**

BACKGROUND OF THE INVENTION

The present application relates generally to apparatus and methods for detecting arc faults, and more specifically to arc fault detection apparatus and methods that are less susceptible to nuisance tripping.

Arc fault detection apparatus and methods are known that employ a micro-controller to measure voltages associated with a load, and to process data representing the voltage measurements to determine the presence of electrical arcing. For example, a conventional arc fault detection apparatus may be configured to sense an alternating load current, to filter and rectify the AC signal, and to provide the rectified signal to an integrating capacitor. The conventional arc fault detection apparatus may then use a micro-controller to take measurements of the voltage across the integrating capacitor, and to convert the voltage measurements to digital data for subsequent processing by an algorithm. For example, the algorithm may be employed to analyze the measured voltage levels corresponding to respective cycles of the line voltage, and to determine whether the voltage measurements are characteristic of electrical arc faults or nuisance loads such as dimmer loads, appliance thermostat switching, drill current transitions, random line voltage spikes, and/or EMI bursts. In the event the voltage measurements are characteristic of an arc fault, the conventional arc fault detection apparatus typically trips a circuit breaker to disconnect the power line from the circuit.

Although the above-described conventional arc fault detection apparatus has been successfully employed to detect and distinguish between electrical arcing and nuisance loads, there is a need for arc fault detection techniques that have increased reliability. For example, due to the generally chaotic nature of electrical arcing, arc faults typically produce varying numbers of arcing events per half cycle of the line voltage. In contrast, nuisance loads, e.g., triac-controlled dimmer circuits, typically produce the same number of arcing events per half cycle, and may therefore produce arcing events periodically over multiple half cycles. However, conventional arc fault detection apparatus often cannot reliably distinguish between periodic and non-period arcing events, and are therefore prone to nuisance tripping. Moreover, such conventional apparatus frequently have difficulty distinguishing between certain start-up and shutdown conditions and electrical arcing. In addition, although some loads may produce noisy switching signals having relatively large voltage levels, such signals are not necessarily indicative of electrical arcing and may be incorrectly characterized as arc faults by conventional arc fault detection apparatus.

It would therefore be desirable to have improved arc fault detection apparatus and methods that avoid the drawbacks of the above-described conventional apparatus and methods.

US 2004/0095695 A1 discloses an apparatus for detecting an arc fault as defined in the preamble of claim 1. A signal derived from the load conductor is passed through rectification, a high pass filter and a limit amplifier to produce pulses which are integrated to produce a signal that operates a circuit breaker that interrupts the load conductor.

EP 1 429 437 A1 discloses an arc detection apparatus comprising a transformer coupled to the load conductor to produce a signal that is rectified to produce pulses which are integrated in a capacitor. The voltage on the capacitor is examined by a microprocessor according to a three-cycle algorithm to see whether the level on the capacitor is indicative of an arc fault. If so, the microprocessor operates to interrupt the load conductor.

US 6 532 424 B1 discloses an electrical fault detection circuit with a dual mode power supply. This comprises a coupling to the load conductor that produces the differential of the current which is then high pass filtered and passed in parallel through respective bandpass filters, threshhold detectors and one shot pulse generators. The outputs of the pulse generators are ANDed together with the resultant pulse train being input to a micro-controller which has a counter that counts the pulses. The micro-controller trips the power supply if the counter indicates an arc fault.

US 2004/066593 A1 and BENNER C L et al "Practical High-Impedance Fault Detection On Distribution Feeders" IEEE Transactions On Industry Applications, IEEE Service Center, Piscataway, NJ, US, vol. 33, No. 3, May 1997 (1997-05), pages 635-640, disclose arc fault detectors in which various algorithms are combined to decide a fault.

BRIEF SUMMARY OF THE INVENTION

In accordance with the present invention, an apparatus and method for detecting arc faults in accordance with the appended claims are provided that have reduced susceptibility to nuisance tripping. In one embodiment, the arc fault detection apparatus includes a current sensor, an input sense circuit, an arcing sense circuit, a power supply, a tripping (firing) circuit, a processing unit, and an electromechanical interface. In one mode of operation, the current sensor monitors a Power Input comprising an alternating current (AC), and provides high frequency components of the AC current to the input sense circuit. Next, the input sense circuit filters and rectifies the AC signal at its input, and provides the rectified signal to the arcing sense circuit. The arcing sense circuit then provides a voltage level accumulated over a predetermined sampling period, and one or more digital signals indicative of possible electrical arcing occurring during the sampling period, to the processing unit. The processing unit is operative to measure the voltage level, to store information relating to measured voltages and the digital signals provided thereto, and to process the stored information using one or more algorithms, thereby determining whether the signals resulted from an arc fault or a nuisance load. In the event the signals resulted from an arc fault, the processing unit activates the firing circuit to trip the electromechanical interface, thereby interrupting the Power Output to the load.

In the presently disclosed embodiment, the micro-controller executes a plurality of algorithms for distinguishing between arc faults and nuisance loads, including a three cycle algorithm (TCA) operative to determine voltage fluctuations that cancel disturbances caused by nuisance loads of the type that are repetitive or continuously varying. The TCA may be expressed as

$$TCA = |(|V_{[n-1]} - V_{[n]}| + |V_{[n+1]} - V_{[n]}| - |V_{[n+1]} - V_{[n-1]}|)|,$$

in which V[n-1] represents a first voltage measurement corresponding to a first cycle of the line voltage, V[n] represents a second voltage measurement corresponding to a second cycle of the line voltage, and V[n+1] represents a third voltage measurement corresponding to a third cycle of the line voltage. The plurality of algorithms further include a first pulse counter algorithm for counting the number of arcing events occurring during each half cycle of the line voltage, a second pulse counter algorithm for capturing timing information relating to one or more arcing events, and an arcing event counter algorithm for counting the number of arcing events included in at least one running sum of voltage measurements. By executing one or more algorithms to distinguish between arc faults and nuisance loads, the arc fault detection apparatus can detect arc faults with increased reliability, thereby reducing the susceptibility of the apparatus to nuisance tripping.

Other features, functions, and aspects of the invention will be evident from the Detailed Description of the Invention that follows.

BRIEF DESCRIPTION OF THE SEVERAL VIEWS OF THE DRAWINGS

The invention will be more fully understood with reference to the following Detailed Description of the Invention in conjunction with the drawings of which:

Fig. 1a is a block diagram of an arc fault detection apparatus according to the present invention;

Fig. 1b is a schematic diagram illustrating the arc fault detection apparatus of Fig. 1a;

Figs. 2a-2b are diagrams illustrating transformer configurations that may be employed in the arc fault detection apparatus of Fig. 1a;

Figs. 2c-2d are views illustrating a transformer included in the transformer configurations of Figs. 2a-2b;

Figs. 3a-3b are schematic diagrams illustrating sum of logarithm circuits that may be employed in the arc fault detection apparatus of Fig. 1a;

Fig. 3c-3d are schematic diagrams illustrating comparator circuits that may be employed in the arc fault detection apparatus of Fig. 1a;

Fig. 4 is a flow diagram illustrating a method of operation including a three cycle algorithm performed by the arc fault detection apparatus of Fig. 1a;

Figs. 5a-5b are flow diagrams illustrating pulse counter algorithms performed by the arc fault detection apparatus of Fig. 1a;

Fig. 6 is a table illustrating the mapping of measurement data sets employed by the pulse counter algorithms of Figs. 5a-5b;

Fig. 7 is a flow diagram illustrating an arcing event counter algorithm performed by the arc fault detection apparatus of Fig. 1a;

Fig. 8 is a flow diagram illustrating a method of integrating the output of a comparator circuit using a digital counter performed by the arc fault detection apparatus of Fig. 1a; and

Fig. 9 is a flow diagram illustrating a method of operation including the pulse counter algorithm of Figs. 5a-5b, the three cycle algorithm of Fig. 4, and the arcing event counter algorithm of Fig. 7 performed by the arc fault detection apparatus of Fig. 1a.

DETAILED DESCRIPTION OF THE INVENTION

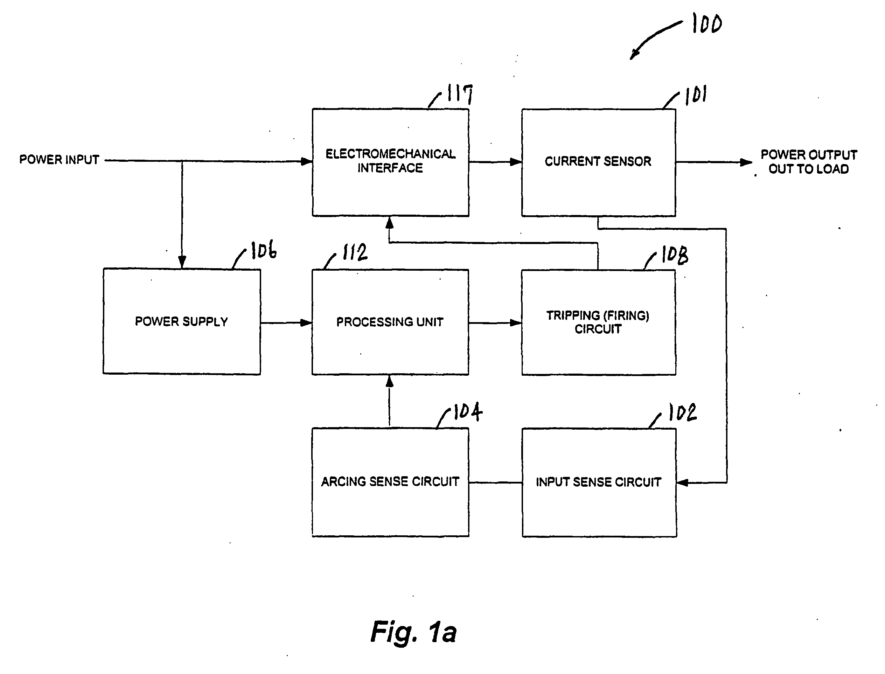

Fig. 1a depicts an illustrative embodiment of an arc fault detection apparatus 100, in accordance with the present invention. In the illustrated embodiment, the apparatus 100 comprises a current sensor 101, an input sense circuit 102, an arcing sense circuit 104, a power supply 106, a tripping (firing) circuit 108, a processing unit 112, and an electromechanical interface 117. In an illustrative mode of operation, the current sensor 101 monitors a Power Input via an electromechanical interface 117, and provides high frequency components of the Power Input to the input sense circuit 102. Next, the input sense circuit 102 filters and rectifies the AC signal at its input, and provides the rectified signal to the arcing sense circuit 104. The arcing sense circuit 104 then provides voltage levels and digital signals indicative of possible electrical arcing to the processing unit 112. Next, the processing unit 112 measures the voltage levels and analyzes the voltage measurements and the digital signals using one or more algorithms to determine whether the signals resulted from an arc fault or a nuisance load. In the event the signals resulted from an arc fault, the processing unit 112 activates the firing circuit 108, thereby tripping the electromechanical interface 117 to disconnect the Power Output from the load. By determining whether the AC signal sensed by the input sense circuit 102 resulted from electrical arcing or from a nuisance load before tripping the electromechanical interface 117, the processing unit 112 reduces the susceptibility of the arc fault detection apparatus 100 to nuisance tripping.

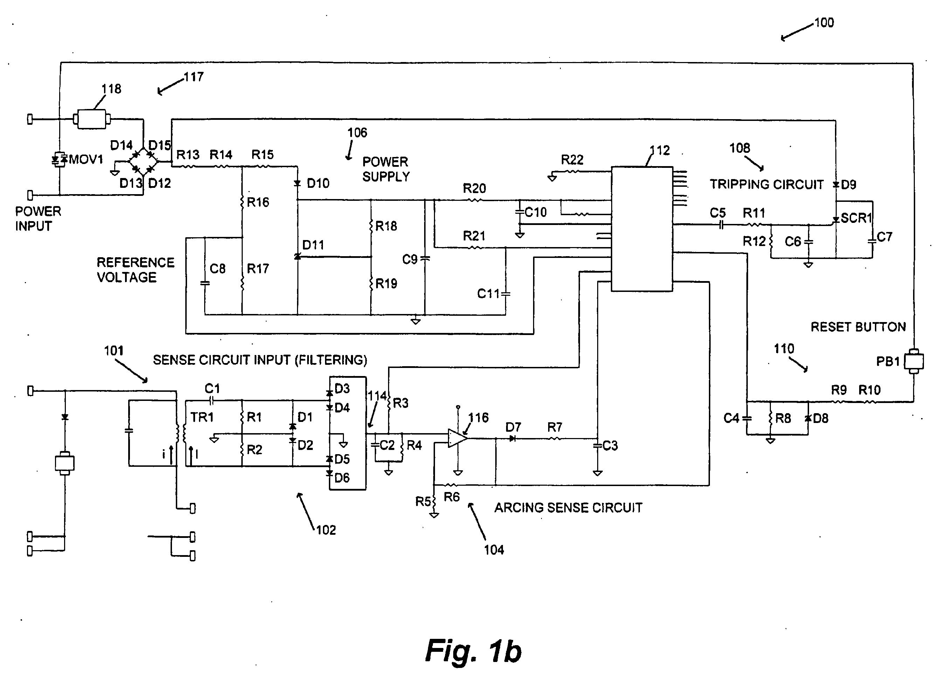

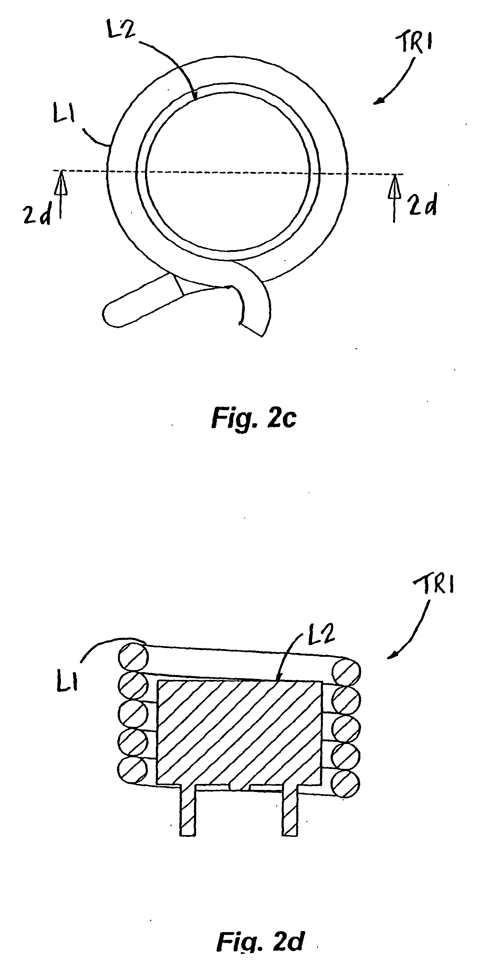

Fig. 1b depicts an illustrative implementation of the arc fault detection apparatus 100. In the illustrated embodiment, the current sensor 101 includes a transformer TR1, which monitors the Power Input by monitoring an alternating current (AC) i flowing through a load coupleable to the Power Output via a load line phase terminal TP9 and load neutral terminals TP10 and TP22. The transformer TR1 is configured for magnetically coupling the high frequency components of the AC current i from its primary coil L1 to its secondary coil L2, thereby providing an AC current I to the input sense circuit 102. In the presently disclosed embodiment, the arc fault detection apparatus 100 is implemented on a substrate such as a laminated printed circuit board (PCB) substrate, a ceramic substrate, or any other suitable substrate. Further, the primary coil L1 of the transformer TR1 surrounds the secondary coil L2 (see Figs. 2c-2d), which has a magnetic axis perpendicular to the substrate. In the preferred embodiment, the secondary coil L2 of the transformer TR1 provides a relatively weak magnetic coupling. For example, the weakly coupled transformer TR1 may provide a mutual conductance of about 20-50 μH.

As shown in Fig. 1b, the input sense circuit 102 includes a capacitor C1, resistors R1-R2, and diodes D1-D6. The secondary coil L2 of the transformer TR1 is connected between the capacitor C1 and the resistor R2. The capacitor C1 is also connected to the resistor R1, and the resistors R1-R2 are connected to ground. The capacitor C1 high pass filters the AC signal provided by the transformer secondary coil L2, and the resistors R1-R2 provide a ground reference for the secondary coil L2. The cathode of the diode D1 is connected to the capacitor C1 and the resistor R1, the cathode of the diode D2 is connected to the secondary coil L2 and the resistor R2, and the anodes of the diodes D1-D2 are connected to ground. The cathode of the diode D1 is also connected to the anodes of the diodes D3-D4, and the cathode of the diode D2 is also connected to the anodes of the diodes D5-D6. The cathodes of the diodes D4-D5 are connected to ground, and the cathodes of the diodes D3 and D6 are connected to a node 114 providing the output of the input sense circuit 102. The diodes D1-D2 and D4-D5 are configured to form a full wave rectified bridge, and therefore the output provided at the node 114 is a full wave rectified signal. In the preferred embodiment, the diodes D3 and D6 are matched to the diodes D4-D5. Further, the diodes D3-D6 and a capacitor C2 included in the arcing sense circuit 104 form a logging circuit, thereby causing the level of the output provided at the node 114 to be proportional to the log of the input of the input sense circuit 102.

In the illustrated embodiment, the arcing sense circuit 104 includes the capacitor C2, an integrating capacitor C3, resistors R3-R7, an operational amplifier (op amp) 116, and a diode D7. As shown in Fig. 1a, the capacitor C2 and the resistor R4 are connected between the node 114 and ground. Further, the resistor R3 is connected between the node 114 and pin 10 of a micro-controller, which performs the functions of the processing unit 112 (see Fig. 1a). The op amp 116 and the resistors R5-R6 are configured to form a non-inverting amplifier 105. The capacitor C2 is connected to the non-inverting input of the op amp 116, and the voltage across the capacitor C2 is buffered and provided to the integrating capacitor C3 via the diode D7 and the resistor R7. The capacitor C3 is connected between pin 9 of the micro-controller 112 and ground. The diode D7 is configured to prevent reverse current flow from the capacitor C3. Further, the combination of the resistor R7 and the capacitor C3 forms a low pass filter to filter out high frequency noise.

It is noted that the voltage across the capacitor C2 resets with a decay time of about (C2)*(R4) seconds. For example, if R4 equals 10 kΩ and the capacitor C2 equals 1 nf, then the decay time of the capacitor C2 is about 10 μsec.

The arcing sense circuit 104 is configured to convert a change in voltage across the capacitor C2 ($\Delta V_{C2}$) into a pulse having a width tpw, which may be determined from

$$G * \Delta V_{C2} * e^{(-tpw/C2 \cdot R4)} = Vcc/2, \qquad (1)$$

in which "G" is the gain of the op amp 116. Each pulse generated in response to a significant di/dt event ("an arcing event") causes a change in voltage across the capacitor C3 ($\Delta V_{C3}$), which may be expressed as

$$\Delta V_{C3} = (Vcc - Vbe - V_{C3}) * (1 - e^{(-tpw/C3 \cdot R7)}) - V_{C3}. \qquad (2)$$

Accordingly, equations (1)-(2) demonstrate that as the number of arcing events increases, $\Delta V_{C3}$ ; increases with the log of $\Delta V_{C2}$, thereby increasing the dynamic range of the arc fault detection apparatus 100.

The micro-controller 112 is operative to take measurements of the voltage $V_{C3}$ across the integrating capacitor C3 at pin 9 of the micro-controller. For example, the micro-controller 112 may comprise a MSP430F1122 micro-controller sold by Texas Instruments Inc. (TI), Dallas, Texas, USA, or any other suitable micro-controller. In one embodiment, the micro-controller 112 measures the voltage $V_{C3}$ across the capacitor C3 once each half cycle of the line voltage near the line voltage zero crossing. The measured voltages represent the sum of voltages accumulated by the integrating capacitor C3, which is reset via a simple decay time. Accordingly, a sampling period during which each measurement is made has a duration starting when an arcing event occurs and lasting for about a decay time.

In alternative embodiments, the micro-controller 112 measures the voltage $V_{C3}$ across the integrating capacitor C3 multiple times per half cycle of the line voltage. For example, the micro-controller 112 may measure the voltage $V_{C3}$ twice each half cycle at times determined by the absolute value of the line voltage, and reset the capacitor C3 to 0 volts following each measurement. Specifically, the micro-controller 112 measures the voltage $V_{C3}$ at times corresponding to two predetermined regions of each half cycle. The micro-controller 112 then sums these measurements by first resetting the capacitor C3 to 0 volts at the beginning of each predetermined region, and then measuring the capacitor voltage at the end of each region. In the preferred embodiment, both voltage measurements per half cycle are made near the line voltage zero crossing, e.g., one measurement is made just before the zero crossing, and the other measurement is made just after the zero crossing.

In the presently disclosed embodiment, pin 9 of the micro-controller 112 is connected to an analog to digital converter (ADC) within the micro-controller 112. The ADC converts the analog voltage measurements taken across the integrating capacitor C3 to digital data, thereby allowing the micro-controller 112 to store the measurement data in internal memory. Following each measurement, the micro-controller 112 shorts pin 9 to ground to prepare the capacitor C3 to integrate current for the next sampling period. In addition, pin 10 of the micro-controller 112 is connected to the output of the op amp 116, which provides a pulse counter signal directly to pin 10 of the micro-controller 112. The micro-controller 112 employs an internal counter to monitor the pulse counter signal to keep track of pulses occurring within the signal. The micro-controller 112 then stores data relating to the measured voltages and the monitored pulses, and processes the data using one or more algorithms to determine whether the voltages/pulses were generated by an arcing event or by a nuisance load.

The arc fault detection apparatus 100 further comprises a reset circuit 110, which includes a capacitor C4, resistors R8-R10, a zener diode D8, and a pushbutton PB1 operable to connect the line phase to pin 12 of the micro-controller 112. In the illustrated embodiment, the serially connected resistors R9-R10 and the resistor R8 connected between pin 12 and ground reduce the line voltage and the line current to levels suitable for the micro-controller 112. Even though the TI MSP430F1122 micro-controller includes internal protection diodes, the zener diode D8 is connected between pin 12 and ground to provide a redundant voltage limitation. The capacitor C4 is connected between pin 12 and ground to filter out high frequency noise. When the pushbutton PB1 is actuated to initiate a test, the micro-controller 112 provides a sense test signal having an increasing pulse width at pin 10. As a result, the micro-controller 112 applies increasing voltage to the capacitor C2 through the resistor R3 as the width of the pulse increases, thereby creating simulated electrical arcing at varying voltages.

As shown in Fig. 1b, the firing circuit 108 includes capacitors C5-C7, resistors R11-R12, a diode D9, and a silicon controlled rectifier (SCR1). Specifically, the capacitor C7 is connected between the anode and the cathode of the SCR1, and the capacitor C6 and the resistor R12 are connected between the gate and the cathode of the SCR1 to prevent an unintentional turn-on of the SCR1 by a significant dv/dt event. The capacitor C5 is serially connected between pin 14 of the micro-controller 112 and the current limiting resistor R11 to prevent excessive depletion of the power supply. The electromechanical interface 117 includes a diode bridge including diodes D12-D15, a solenoid 118, and a metal oxide varistor (MOV1) connected between the line neutral and line phase terminals to prevent excessive line voltage. The diode D9 is connected between the diode bridge D12-D15 and the anode of the SCR1. The diode D9 isolates the capacitor C7 from a line voltage monitoring circuit including the resistors R16-R17 and the capacitor C8 connected to pin 8 of the micro-controller 112. Accordingly, when the SCR1 is turned on, the SCR1 draws increased current through the diode bridge D12-D15, and a voltage level approximately equal to the line voltage trips the solenoid 118 to disconnect the Power Output from the load.

In the illustrated embodiment, the power supply 106 includes resistors R13-R20, capacitors C8-C10, and diodes D10-D11. The serially connected resistors R13-R15 limit the amount of current provided to the zener diode D11. As shown in Fig. 1b, the resistor R20 is connected between the junction of the diode D10 and the zener diode D11 and the positive supply Vcc (pin 2) of the micro-controller 112. The diode D10 prevents reverse current flow from the capacitor C9, which is connected between the junction of the diodes D10-D11 and ground. Further, the capacitor C10, which is connected between pin 2 of the micro-controller 112 and ground, provides the voltage Vcc to the micro-controller 112. The serially connected resistors R16-R17 are connected between the junction of the resistors R14-R15 and ground. Further, the capacitor C8, which is connected between the junction of the resistors R16-R17 and ground, provides a reference voltage (VREF) to pin 8 of the micro-controller 112. The reference voltage VREF is proportional to the voltage of the diode bridge D12-D15, which is approximately equal to the absolute value of the line voltage. In the presently disclosed embodiment, the micro-controller 112 monitors the line voltage via VREF, and determines when to perform measurements of the voltage across the capacitor C3 based on the monitored line voltage. In an alternative embodiment, the micro-controller 112 may monitor the output of a digital timer and perform voltage measurements across the integrating capacitor C3 based on the timer output.

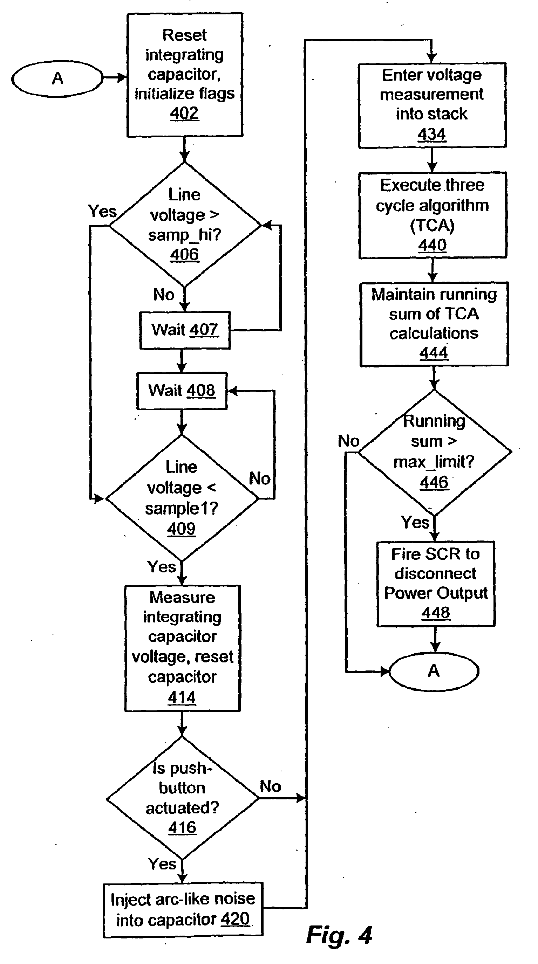

As described above, the micro-controller 112 determines the occurrence of arcing events by processing stored voltage/pulse data using one or more algorithms. A method of operating the arc fault detection apparatus 100 that employs a three cycle algorithm (TCA) to reduce the occurrence of tripping on nuisance loads is described below with reference to Figs. 1b and 4. As depicted in step 402, the integrating capacitor C3 is reset to 0 volts and all flags within the micro-controller 112 are initialized. Steps 406-409 form a subroutine in which the method continues to loop until the until the reference voltage VREF monitored at pin 8 of the micro-controller 112 exceeds a predetermined value samp_ hi and then goes below a selected value sample1, thereby defining a sampling or measurement point near the line voltage zero crossing. A measurement of the voltage across the capacitor C3 is then made, as depicted in step 414, at pin 9 of the micro-controller 112, after which the capacitor C3 is reset to 0 volts. Next, a determination is made, as depicted in step 416, as to whether the pushbutton PB1 is actuated. In the event the pushbutton PB1 is actuated, electrical arc-like noise is injected, as depicted in step 420, into the capacitor C2 through the resistor R3 connected to pin 10 of the micro-controller 112 which, with sufficient noise injected over a plurality of half cycles of the line voltage and processed by the TCA in step 440 described below, causes the solenoid 118 to trip in the same manner as a detected electrical arc in the load current.

In the preferred embodiment, because a minimal voltage is required to sustain an electrical arc, e.g., about 15 volts, a window typically up to 50 volts is selected for voltage measurement to account for phase differences between the line current and the line voltage. This window around the line voltage zero crossing captures relatively small arcs that are typically generated or extinguished near the zero crossing.

Next, the voltage measurement is converted to digital form and pushed, as depicted in step 434, onto a stack within the micro-controller 112 to maintain a history of measurement data. In the presently disclosed embodiment, successive voltage measurement values are entered as words into the stack. The TCA is then executed, as depicted in step 440. Specifically, the word of cycle 1 (*i.e.,* V[n-1]) minus the word of cycle 2 (*i.e.,* V[n]) is calculated and the absolute value is taken to obtain a first calculated value, the word of cycle 3 (i.e., V[n+1]) minus the word of cycle 2 (i.e., V[n]) is calculated and the absolute value is taken to obtain a second calculated value, and the word of cycle 3 (i.e., V [n+1]) minus the word of cycle 1 (i.e., V[n-1]) is calculated and the absolute value is taken to obtain a third calculated value. The first value plus the second value minus the third value is then calculated and the absolute value is taken. The TCA executed in step 440 may therefore be expressed as

$$TCA = |(|V_{[n-1]} - V_{[n]}| + |V_{[n+1]} - V_{[n]}| - |V_{[n+1]} - V_{[n-1]}|)|. \qquad (3)$$

It is understood that the outermost pair of absolute value signs in equation (3) are not strictly required, but are included to emphasize the need to avoid the occurrence of least significant bit (LSB) errors during execution of the TCA. It is noted that the adjacent full cycles 1-3 employed in the TCA may or may not be overlapping. If the three cycles are not overlapping, then six half cycles are required to execute the TCA. If the three cycles are overlapping, then only four half cycles are required for the TCA.

Next, at least one continuous running sum of TCA calculations is maintained, as depicted in step 444. Each running sum of TCA calculations represents the total amount of electrical arcing that occurs over a respective sampling period. At the end of the sampling period, a determination is made, as depicted in step 446, as to whether the running sum exceeds a predetermined maximum threshold value max_limit. In the event the running sum value exceeds max_limit, an arc fault is detected and the SCR1 is fired, as depicted in step 448, to disconnect the Power Output from the load. In the preferred embodiment, the SCR1 is fired three times to assure firing even if there is a brief interruption of the line voltage. In the presently disclosed embodiment, a pulse having a selected width, e.g., 30 μsec, is provided to the SCR1. The method then loops back to step 402 to prepare the integrating capacitor C3 for subsequent voltage measurements.

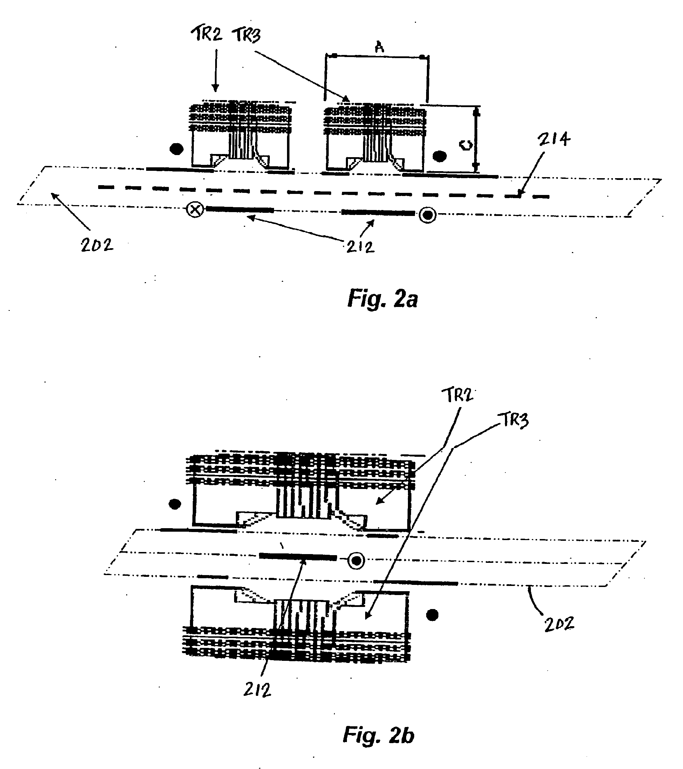

Having described the above illustrative embodiments, other alternative embodiments or variations may be made. For example, it was described that the arc fault detection apparatus 100 is implemented on a substrate, and that the primary coil L1 of the transformer TR1 surrounds an inductive pickup coil having a magnetic axis that is perpendicular to the substrate. Fig. 2a depicts a first alternative embodiment, in which the primary coil L1 is implemented as a first U-shaped conductive trace 212 disposed in and parallel to a substrate 202. In this embodiment, the magnetic axis of the inductive pickup coil is parallel to the substrate 202, and the current flowing through the primary coil L1 is perpendicular to the axis of the pickup coil. As shown in Fig. 2a, an electrostatic shield comprising a second conductive trace 214 is disposed between the first trace and the pickup coils. It is noted that the transformer TR1 may be implemented as a single surface mount pickup coil, or as two surface mount pickup coils TR2-TR3 to provide a grounded center tap for reducing capacitive coupling between the primary and pickup coils. In the presently disclosed embodiment, the polarity of the two pickup coils TR2-TR3 is independent of 180° rotation about an axis perpendicular to the magnetic axis. In addition, the substrate 202 functions as an insulator between the primary coil 212 and the pickup coils.

As shown in Fig. 2a, the two surface mount pickup coils TR2-TR3 are disposed on one side of the substrate 202, and the primary coil trace 212 is underneath and perpendicular to the magnetic axes of the pickup coils. It is appreciated that the U-shaped trace 212 of the primary coil L1, which is connected to the line current, may be replaced by one line current trace and one return current trace. In this way, arc detection capability may be provided even if the line and return connections are reversed.

Fig. 2b depicts a second alternative embodiment, in which the two surface mount pickup coils TR2-TR3 are placed substantially opposite one another on opposing sides of the substrate 202, and the primary coil trace 212 is disposed between the pickup coils, thereby providing increased mutual inductance. For example, each pickup coil may comprise a 5315TC (Ferrite) series RFID transponder coil sold by Coilcraft Corporation, Cary, Illinois, USA, or any other suitable pickup coil.

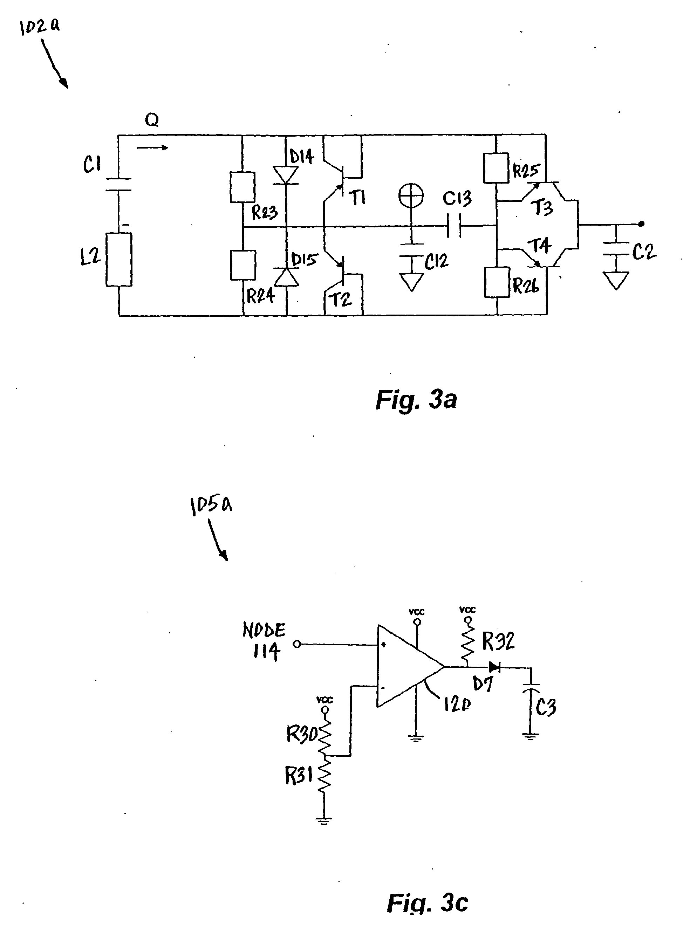

It was also described that the input sense circuit 102 (see Fig. 1b) may be configured to allow the micro-controller 112 to perform voltage measurements once per half cycle of the line voltage. Fig. 3a depicts a sum of logarithm circuit 102a, which is a first alternative embodiment of the input sense circuit 102. Like the input sense circuit 102, the sum of logarithm circuit 102a allows the micro-controller 112 to measure the voltage across the capacitor C3 once per half cycle near the line voltage zero crossing. As shown in Fig. 3a, the sum of logarithm circuit 102a includes the capacitor C1, capacitors C12-C13, resistors R23-R26, diodes D14-D15, and transistors T1-T4. The transistors T1-T4 and the capacitor C13 form a logging circuit, and the change in voltage across the capacitor C13 may be expressed as

$$\Delta V_{C13} \approx vT * \ln(|Q|/(C*vT)+1), \qquad (4)$$

in which "|Q|" is equal to the arc-produced charge flowing through the primary coil L1 of the transformer TR1, and

$$vT = kT/q, \qquad (5)$$

in which "vT" is equal to about 26 mV at room temperature. In the presently disclosed embodiment, each arcing event increases the voltage across the capacitor C2 by (C13/C2)*ΔV. Further, the voltage across the capacitor C13 resets with a decay time of about (C13)*(R23) seconds. For example, if each one of the resistors R23-R26 equals 10 kΩ and the capacitor C13 equals 10 nf, then the decay time is about 100 μsec. Accordingly, the charge injected by an arcing event into the capacitor C1 equals the charge injected into the capacitor C13, beginning at the time of the arcing event and ending about a decay time later.

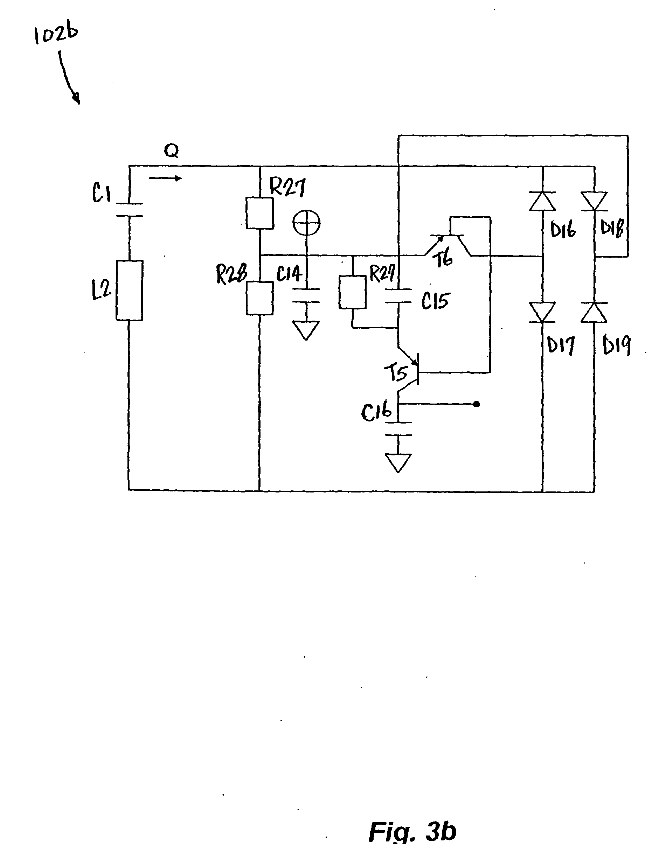

Fig. 3b depicts a sum of logarithm circuit 102b, which is a second alternative embodiment of the input sense circuit 102 (see Fig. 1b). As shown in Fig. 3b, the sum of logarithm circuit 102b includes the capacitor C1, resistors R27-R29, capacitors C14-C16, transistors T5-T6, and diodes D16-D19. In this alternative embodiment, the sum of logarithm circuit 102b employs only one matched transistor pair T5-T6 in the logging circuit.

It was also described that the arcing sense circuit 104 (see Fig. 1b) includes the op amp 116 and the resistors R5-R6, which form a non-inverting amplifier 105. Fig. 3c depicts a comparator circuit 105a that may be employed in place of the non-inverting amplifier 105. As shown in Fig. 3c, the comparator circuit 105a includes a comparator 120, resistors R30-R32, the diode D7, and the capacitor C3. Specifically, the resistors R30-R31 form a voltage divider that biases the inverting input of the comparator. When the level of the signal provided to the non-inverting input of the comparator 120 by the input sense circuit 102 exceeds the level at the inverting input of the comparator 120, the comparator 120 charges the capacitor C3 through the resistor R32 at a rate proportional to (R32)*(C3). It is noted that the capacitor C3 continues to charge the capacitor C3 so long as the signal level at the non-inverting input of the comparator 120 remains greater than Vcc*[R31/R30+R31)]. Accordingly, each time a significant change in load current is detected at the input of the comparator circuit 105a (i.e., each time a significant di/dt event occurs), the output of the comparator is driven to its positive rail, thereby generating a pulse for charging the capacitor C3 through the diode D7 and the resistor R7.

In the presently disclosed embodiment, the micro-controller 112 is operative to execute a first pulse counter algorithm to count the number of times the output of the comparator circuit 105a (or the non-inverting amplifier 105) is driven high during each half cycle. Due to the generally chaotic nature of electrical arcing, arc faults typically produce varying numbers of arcing events per half cycle of the line voltage. In contrast, nuisance loads typically produce the same number of arcing events per half cycle, and may therefore produce arcing events periodically over multiple half cycles. Such information may be used to inhibit nuisance tripping under normal operating conditions, and to allow tripping to occur when arc faults are detected. Specifically, the comparator circuit 105a provides the pulse counter signal to pin 13 of the micro-controller 112, which uses this signal during the execution of the first pulse counter algorithm. Each time the output of the comparator circuit 105a is driven high during each half cycle, as indicated by the level of the pulse counter signal, a digital counter within the micro-controller 112 is incremented. When the capacitor C3 is reset by the micro-controller 112, the counter value is stored within the micro-controller 112, and the first pulse counter algorithm is executed. In the presently disclosed embodiment, the micro-controller 112 executes the first pulse counter algorithm to determine the periodicity of a predetermined number of data elements in one or more measurement data sets stored in the micro-controller 112. For example, in the event the stored counter value is equal to four, the first pulse counter algorithm may be used to determine the periodicity of 1-4 data elements in at least one measurement data set.

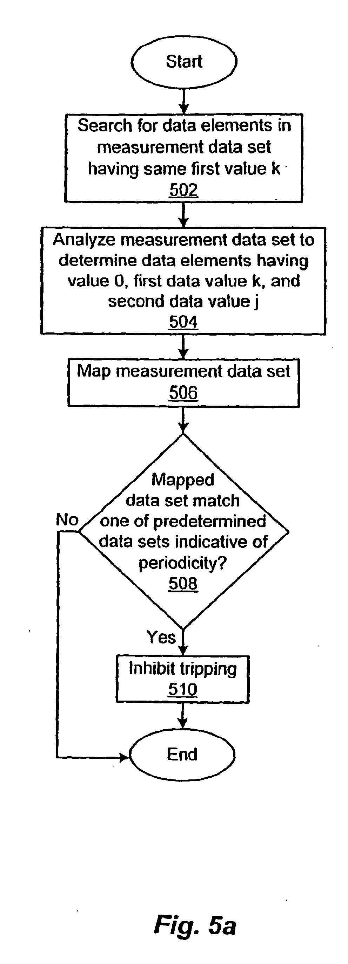

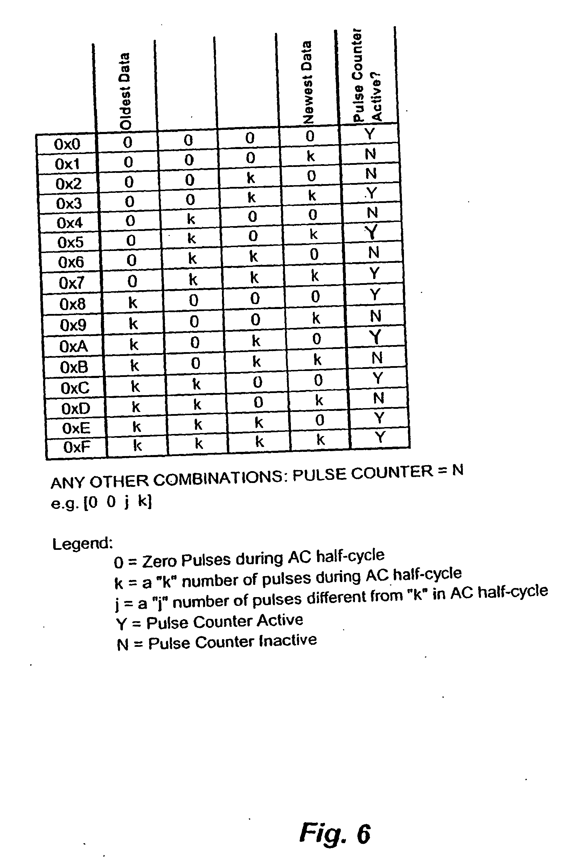

The operation of the first pulse counter algorithm is described below with reference to Fig. 5a. As depicted in step 502, the pulse counter algorithm searches for a predetermined number of data elements in a set of measurement data having the same first data value k. The entire measurement data set is then analyzed, as depicted in step 504, to determine the presence of data elements having a value of zero (0's), to determine the presence of additional data elements having the first data value (k's), and to determine the presence of data elements having a second data value different from the first data value (j's). Next, the data set is mapped, as depicted in step 506. For example, an exemplary data set may contain a first data element having a zero value, a second data element having a first value of 3, a third data element having the same first value of 3, and a fourth data element having a different second value of 2, and may therefore be mapped to [0,k,k,j]. Next, a determination is made, as depicted in step 508, as to whether the mapped data set matches at least one of a plurality of predetermined data sets indicative of the periodicity of multiple arcing events. As explained above, nuisance loads typically produce periodic arcing events, while arcing events produced by arc faults are typically non-periodic. In addition, certain start-up and shutdown conditions may resemble periodic arcing events. Fig. 6 depicts an illustrative mapping of a plurality of data sets indicative of periodic arcing events. For example, the exemplary mapping [0,k,k,j] described above does not match any of the data sets shown in Fig. 6. In this case, the pulse counter is not regarded as being "active" (N) and tripping is allowed. In the event a match is made, as depicted in step 510, the pulse counter is regarded as being "active" (Y) and tripping is inhibited, thereby reducing the occurrence of nuisance tripping under normal operating conditions. For example, tripping may be inhibited by increasing the predetermined maximum threshold value max_limit and/or any other suitable constant and/or coefficient employed by the above-described three cycle algorithm (TCA). It is understood that the constants/coefficients employed by the TCA may also be suitably modified to enable tripping when significant arc faults are detected.

As described above, the first pulse counter algorithm includes the step of determining whether a mapped data set matches at least one predetermined data set indicative of the periodicity of an arcing event. In an alternative embodiment, a determination may also be made as to whether the mapped data set matches one or more predetermined data sets indicative of insignificant events (e.g., noise) in the data history. For example, such a data set may map to [0,k,k,j,k,k], which would be indicative of periodicity but for the single "j" element in the mapping. By inhibiting tripping when such a match occurs, a degree of noise filtering may be incorporated into the first pulse counter algorithm.

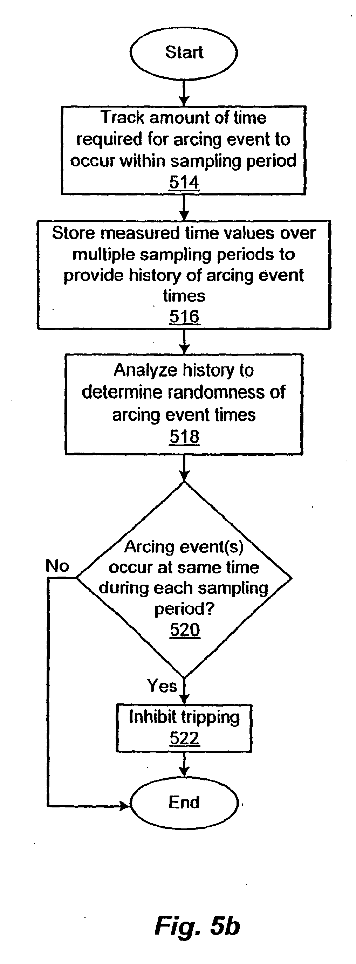

In the presently disclosed embodiment, a second pulse counter algorithm is also executed to capture timing information relating to one or more arcing events. The second pulse counter algorithm is described below with reference to Fig. 5b. As depicted in step 514, the counter within the micro-controller 112 is employed to track the amount of time required for an arcing event to occur within the sampling period. For example, the counter may be used to measure the time from the beginning of the sampling period to the occurrence of an arcing event within the sampling period. A plurality of measured time values is then stored, as depicted in step 516, over a number of sampling periods to provide a history of arcing event times. Next, the time history is analyzed, as depicted in step 518, to determine the randomness of the arcing times. A determination is then made, as depicted in step 520, as to whether an arcing event occurs at substantially the same time during each sampling period. In the event the arcing occurs at substantially the same time during each sampling period, the arcing is deemed to be caused by a nuisance load and tripping is inhibited, as depicted in step 522. It is understood that the constants/coefficients employed by the above-described three cycle algorithm may be suitably modified to inhibit and/or enable tripping based on the arc timing history obtained by the second pulse counter algorithm.

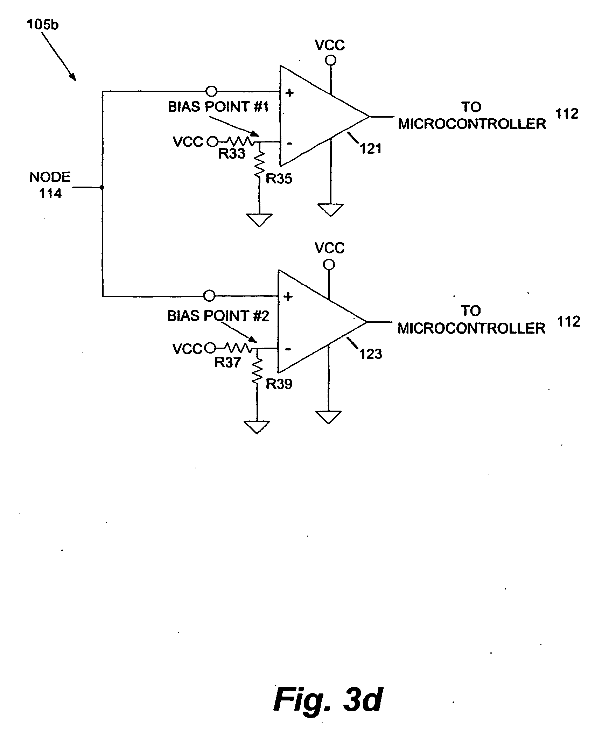

To account for the non-linearity of electrical arcing signals, the comparator circuit 105a may be modified to provide multiple digital output signals corresponding to respective voltage threshold values. Fig. 3d depicts an illustrative embodiment of a comparator circuit 105b providing multiple digital outputs. As shown in Fig. 3d, the comparator circuit 105b includes comparators 121 and 123, and resistors R33, R35, R37, and R39. Further, the non-inverting inputs of the comparators 121 and 123 are connectable to the node 114 (see Fig. 1b), and the outputs of the comparators 121 and 123 are connectable to suitable digital inputs of the micro-controller 112. Specifically, the resistors R33, R35, and R37, R39 form voltage dividers that bias the inverting inputs of the comparators 121 and 123, respectively. For example, the voltage dividers may bias the comparators 121 and 123 at predetermined low and high voltage levels, respectively. In this alternative embodiment, the digital counter within the micro-controller 112 starts to increment when the comparator 121 provides a first digital output indicating that the level of the arcing signal has exceeded the low voltage threshold. Next, the rate at which the counter is incremented is increased as the arcing level exceeds the high voltage threshold, as indicated by a second digital output provided by the comparator 123. The rate at which the counter is incremented is then decreased as the arcing level goes below the successive thresholds, as indicated by the first and second digital outputs provided by the respective comparators 121 and 123.

It was also described that the TCA may be expressed as

$$TCA = |\, (|\, V_{[n-1]} - V_{[n]}\,| + |\, V_{[n+1]} - V_{[n]}\,| - |\, V_{[n+1]} - V_{[n-1]}\,|)\,|$$

(see equation (3)). However, equation (3) provides a relatively smooth response to single arcing events. To achieve a response to single arcing events that is more characteristic of an impulse, a modified TCA may be expressed as

$$Knob\_TCA = TCA\_1 + (knob) * TCA\_2, \qquad (6)$$

in which "TCA_1" is expressed as equation (3), "knob" is a constant, and "TCA_2" is expressed as

$$TCA\_2 = |V_{[n-1]} - 2 * V_{[n]} + V_{[n+1]}|, \qquad (7)$$

in which V[n-1] represents a first voltage measurement corresponding to a first cycle of the line voltage, V[n] represents a second voltage measurement corresponding to a second cycle of the line voltage, and V[n+1] represents a third voltage measurement corresponding to a third cycle of the line voltage. It is noted that TCA_2 provides more of an impulse response to single arcing events. In equation (6) above, the knob constant may be adjusted (e.g., the knob constant may be set to 1/8 or any other suitable value) to provide varying amounts of impulse response.

It was also described that the resulting sum of the three cycle algorithm (TCA) is added to a continuous running sum of TCA calculations that represents the total amount of electrical arcing occurring over the sampling period. At the end of each sampling period, the running sum is compared to the predetermined maximum threshold value max_limit, and the SCR1 is fired in the event the threshold is exceeded. In an alternative embodiment, to further avoid nuisance tripping, the micro-controller 112 (see Fig. 1) is operative to execute an arcing event counter algorithm to count the number of arcing events included in the running sum.

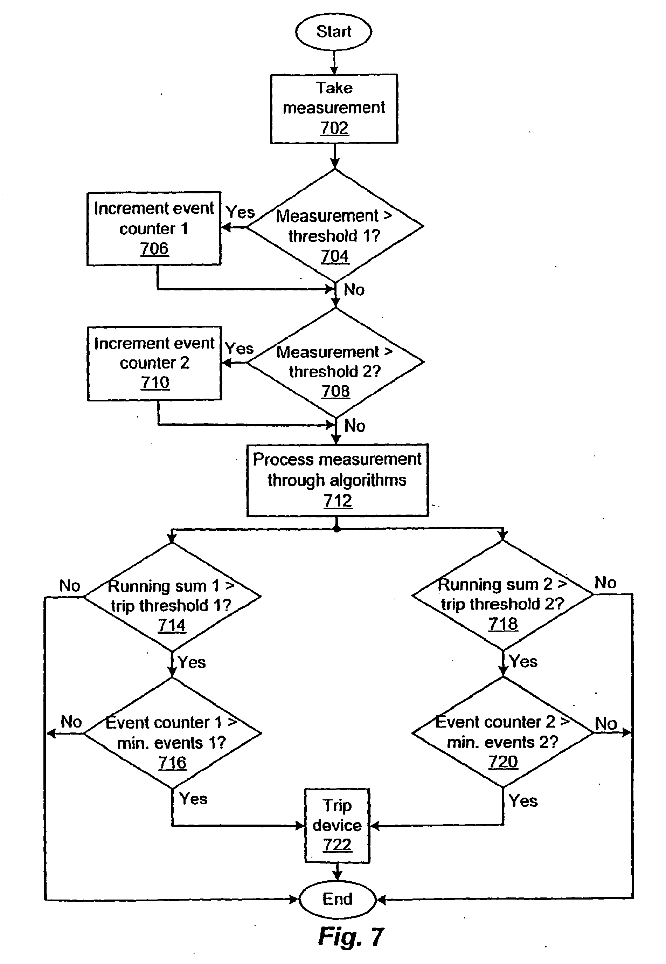

The arcing event counter algorithm is described below with reference to Fig. 7. As depicted in step 702, the voltage across the capacitor C3 is measured. Next, a determination is made, as depicted in step 704, as to whether the measured voltage value exceeds a first predetermined threshold value. If the measured voltage value exceeds the first threshold value, then a first event counter within the micro-controller 112 is incremented, as depicted in step 706. Next, at least one second determination is optionally made, as depicted in step 708, as to whether the measured voltage value exceeds a second predetermined threshold value. If the measured voltage value exceeds the second threshold value, then a second event counter within the micro-controller 112 is incremented, as depicted in step 710. Next, the measurement of the voltage across the capacitor C3 is processed, as depicted in step 712, by at least one algorithm such as the TCA described above. In the preferred embodiment, the voltage measurement is then added to first and second running sums of voltage measurements. For example, the first running sum of voltage measurements may correspond to a short sampling period during which large voltage measurements are monitored over a short period of time, and the second running sum of voltage measurements may correspond to a long sampling period during which smaller voltage measurements are monitored over a longer period of time. As depicted in step 714, a determination is made as to whether the first running sum (running sum 1) exceeds a first predetermined trip threshold (trip threshold 1). In the event the first running sum value exceeds the first trip threshold value, a determination is made, as depicted in step 716, as to whether the output of the first event counter (event counter 1) exceeds a first predetermined minimum number of events (min. events 1). In the event the first event counter output exceeds the first number of events, tripping occurs, as depicted in step 722, to disconnect the Power Output from the load. As depicted in step 718, a determination is made as to whether the second running sum (running sum 2) exceeds a second predetermined trip threshold (trip threshold 2). In the event the second running sum value exceeds the second trip threshold value, a determination is made, as depicted in step 720, as to whether the output of the second event counter (event counter 2) exceeds a second predetermined minimum number of events (min. events 2). In the event the second event counter output exceeds the second number of events, tripping occurs, as depicted in step 722, to disconnect the Power Output from the load. Accordingly, if either the first event counter output exceeds the first predetermined count number or the second event counter output exceeds the second predetermined count number, then tripping occurs. Otherwise, no tripping takes place.

In this way, nuisance tripping due to, e.g., noisy switching signals is avoided. Although such noisy signals may result in relatively large voltage measurements, they are not necessarily indicative of electrical arcing. By monitoring the level of the running sum of measured voltages, and by tracking the number of arcing events included in the running sum, electrical arcing containing several half cycles of arcing events can be more reliably detected, and nuisance loads containing only a limited number of arcing events can be more safely ignored.

It was also described that the micro-controller 112 monitors the line voltage via VREF, and determines when to perform measurements of the voltage across the capacitor C3 based on the monitored line voltage. Under normal operating conditions, the time between these voltage measurements is regular and periodic. However, during high current arcing conditions, the VREF signal can become degraded due to a line voltage drop out caused by a momentary hard short circuit. If the micro-controller 112 is looking for a specific voltage point on the half cycle of the line voltage, then such a voltage drop out could cause an inadvertent or early command to measure. In addition, during this type of arcing event, the voltage on the integrating capacitor C3 is typically relatively high. During a normal line drop out (or brown out), a purported measurement point may be found by the micro-controller, but there may be no abnormal voltage on the capacitor C3. In contrast, during a high current arcing condition, a purported measurement point may be found and a relatively high voltage may be detected on the capacitor C3. Accordingly, to detect high level arcing, the micro-controller 112 is operative to measure the time between measurement points. In the event an early measurement is found and a relatively large capacitor voltage $V_{C3}$ is detected, the micro-controller activates the firing circuit 108, thereby tripping the solenoid 118 to disconnect the Power Output from the load.

It was also described that the micro-controller 112 (see Fig. 1) may take measurements of the voltage across the capacitor C3 twice each half cycle, convert the voltage measurements to digital form using an analog to digital converter (ADC), store the measured voltage data, and discharge the capacitor C3 when the voltage measurements are completed. It is noted that the voltage across the capacitor C3 represents the integral of the signal provided by the non-inverting amplifier 105. In an alternative embodiment, a digital counter within the micro-controller 112 is employed as an accumulator for effectively integrating the output of the non-inverting amplifier 105, thereby obviating the need for the integrating capacitor C3 and the ADC.

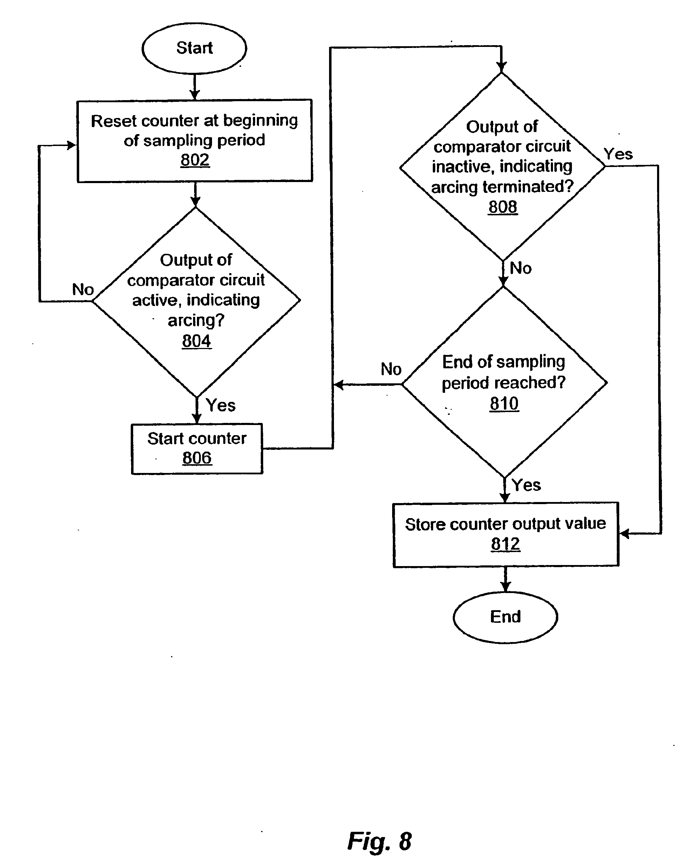

In this alternative embodiment, the comparator circuit 105a or 105b is used in place of the non-inverting amplifier 105, and the digital output(s) of the comparator circuit is provided directly to the micro-controller 112 for incrementing the internal counter. Further, the sampling period is defined as having a duration corresponding to one or more half cycles of the line voltage. The operation of the micro-controller 112 and the internal counter for integrating the output of the comparator circuit 105a is described below with reference to Fig. 8. As depicted in step 802, the counter is reset at the beginning of the sampling period. Next, a determination is made, as depicted in step 804, as to whether the output of the comparator circuit 105a is active, thereby indicating the presence of electrical arcing. In the event the comparator circuit output is active, the counter is started, as depicted in step 806. A determination is then made, as depicted in step 808, as to whether the output of the comparator circuit 105a has become inactive, indicating the termination of electrical arcing. In the event electrical arcing has terminated, the method branches to step 812. Otherwise, a determination is made, as depicted in step 810, as to whether the end of the sampling period has been reached. In the event the end of the sampling period has been reached, the method proceeds to step 812. Otherwise, the method loops back to step 808. Next, the output value of the counter is stored, as depicted in step 812. The stored counter output, which represents the integral of the output of the comparator circuit 105a, is subsequently used in place of the voltage measurements across the integrating capacitor C3 in the arc detection algorithms described above.

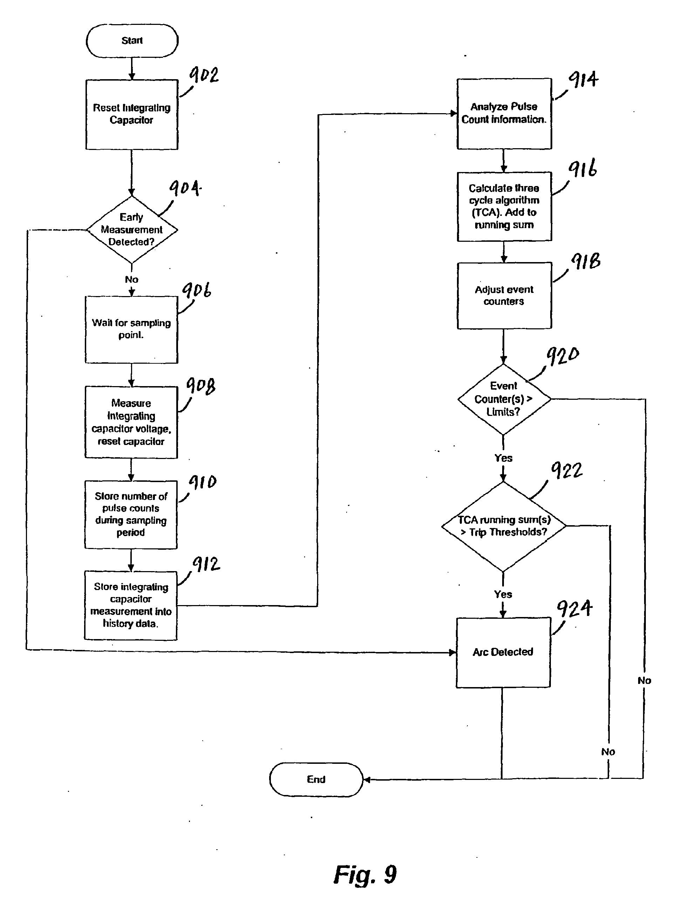

A method of operating the arc fault detection apparatus 100 that employs the arc detection algorithms including the pulse counter algorithm, the three cycle algorithm (TCA), and the arcing event counter algorithm is illustrated by reference to Figs. 1b and 9. As depicted in step 902, the integrating capacitor C3 is reset to 0 volts. Next, a determination is made, as depicted in step 904, as to whether an early command to measure is detected. For example, the micro-controller 112 may detect such an early command to perform a voltage measurement if the VREF signal becomes degraded due to a line voltage drop out. In the event an early measurement is detected and an excessively large voltage across the capacitor C3 is measured, an arc fault is detected, as depicted in step 924, and the solenoid 118 is tripped to disconnect the Power Output from the load. Otherwise, the micro-controller 112 monitors the VREF signal and waits, as depicted in step 906, for the sampling or measurement point to arrive.

When the measurement point arrives, the voltage across the integrating capacitor C3 is measured, as depicted in step 908, after which the capacitor C3 is reset to 0 volts. Next, the micro-controller 112 monitors the pulse counter signal provided by the arcing sense circuit 104 and stores, as depicted in step 910, the number of pulse counts occurring during the sampling period. In addition, the micro-controller 112 stores, as depicted in step 912, the integrating capacitor voltage measurement into the history data store (e.g., a stack). The stored pulse count information is then analyzed, as depicted in step 914, using the above-described pulse counter algorithm. Next, the three cycle algorithm (TCA) is executed, as depicted in step 916, using the stored history of voltage measurement data, and resulting TCA calculations are added to at least one running sum. One or more event counters within the micro-controller 112 are then adjusted, as depicted in step 918, and the voltage measurements are analyzed using the above-described arcing event counter algorithm. A determination is then made, as depicted in step 920, as to whether one or more event counters exceed predetermined minimum numbers of arcing events. If the event counter(s) exceeds the predetermined minimum number (s) of arcing events, another determination is made, as depicted in step 922, as to whether the TCA running sum(s) exceeds a predetermined trip threshold value. In the event the TCA running sum(s) exceeds the predetermined trip threshold, an arc fault is detected, as depicted in step 924, and the solenoid 118 is tripped to disconnect the Power Output from the load.

It should be appreciated that the above-described arc fault detection apparatus 100 may also be employed to provide DC arc fault detection. In this case, instead of monitoring the line voltage via VREF to determine when to perform voltage measurements, the micro-controller 112 may alternatively employ an internal digital counter as a time base to generate suitable periods for sampling the voltage across the integrating capacitor C3.

It will further be appreciated by those of ordinary skill in the art that further modifications to and variations of the above-described apparatus and method for detecting arc faults may be made. Accordingly, the invention should not be viewed as limited except as by the scope of the appended claims.

## Claims

1. Arc fault detection apparatus (100), comprising:

   a power input;
   an input sense circuit (102) configured to sense a signal associated with the power input, the sensed signal being indicative of at least one potential arcing event; and
   an arcing sense circuit (104) including an amplifying sub-circuit (116) and an accumulating sub-circuit (D7,R7,C3), the amplifying sub-circuit being configured to receive a representation of the sensed signal and to generate a respective pulse corresponding to the at least one potential arcing event, the accumulating sub-circuit being configured to receive respective pulses generated by the amplifying sub-circuit and to generate an accumulated signal over a predetermined time period;
   a processor (112) operative to receive the accumulated signal from the arcing sense circuit, to generate first data representative of the accumulated signal, and to process the first data in accordance with at least one algorithm to determine whether the at least one potential arcing event is indicative of an arc fault or a nuisance condition,

   characterised in that the processor (112) is further operative to receive the respective pulses from the arcing sense circuit (104), to generate second data representative of the respective pulses, and to process the second data in accordance with at least one algorithm to determine whether the at least one potential arcing event is indicative of an arc fault or a nuisance condition.

2. The apparatus of claim 1 further including a current sensor (TR1) configured to monitor the power input, and to provide the signal associated with the power input to the input sense circuit (102).

3. The apparatus of claim 2 wherein the current sensor comprises a transformer (TR1) having a primary coil and a secondary coil, the secondary coil being weakly coupled to the input sense circuit (102).

4. The apparatus of claim 1 further including a power output and an electromechanical interface (117) coupled between the power input and the power output, wherein the processor (112) is further operative, if the at least one potential arcing event is indicative of an arc fault, to trip the electromechanical interface, thereby disconnecting the power output from a load coupleable thereto.

5. The apparatus of claim 4 wherein the electromechanical interface comprises a solenoid (118).

6. The apparatus of claim 1 wherein the amplifying sub-circuit comprises a comparator sub-circuit (105a).

7. The apparatus of claim 1 wherein the accumulating sub-circuit comprises an integrating capacitor (C3).

8. The apparatus of claim 1 wherein the accumulating sub-circuit comprises a digital counter.

9. The apparatus of claim 1 wherein the amplifying sub-circuit (105b) comprises a plurality of comparators (121,123), each comparator being configured to generate a respective pulse in the event the sensed signal exceeds a respective predetermined threshold, wherein the accumulating circuit comprises a digital counter, and wherein the processor is operative to receive the respective pulses generated by the plurality of comparators, and to increment the digital counter at different rates based on the received pulses.

10. The apparatus of claim 1 wherein the processor (112) is operative to measure the accumulated signal a number of times over a set of cycles, to generate the first data representative of the accumulated signal measurements, and to process the first data in accordance with an algorithm including calculating a first measurement associated with a first cycle minus a second measurement associated with a second cycle to obtain a first calculated value, calculating a third measurement associated with a third cycle minus the second measurement associated with the second cycle to obtain a second calculated value, calculating the third measurement associated with the third cycle minus the first measurement associated with the first cycle to obtain a third calculated value, taking the absolute values of the first, second, and third calculated values, and calculating the first value plus the second value minus the third value to obtain a fourth calculated value.

11. The apparatus of claim 10 wherein the processor (112) is further operative to repeat the processing of the first data in accordance with the algorithm using signal measurements corresponding to at least one different set of cycles, and to maintain a running sum of the fourth calculated values, the running sum being representative of the total amount of electrical arcing occurring during the predetermined time period.

12. The apparatus of claim 11 wherein the processor is further operative to process the second data in accordance with at least one second algorithm to count the number of arcing events included in the running sum.

13. The apparatus of claim 1 wherein the processor (112) is operative to process the second data in accordance with an algorithm for counting the number of arcing events occurring during the predetermined time period.

14. The apparatus of claim 13 wherein the processor is further operative to capture timing information relating to the arcing events.

15. The apparatus of claim 1 wherein the sensed signal is an AC signal.

16. The apparatus of claim 1 wherein the sensed signal is a DC signal.

17. A method of detecting arc faults, comprising the steps.of:

sensing a signal associated with a power input by an input sense circuit (102), the sensed signal being indicative of at least one potential arcing event;
receiving a representation of the sensed signal by an amplifying circuit (116);
generating a respective pulse corresponding to the at least one potential arcing event by the amplifying circuit;
receiving the respective pulses by an accumulating circuit (D7,R7,C3); and generating an accumulated signal over a predetermined time period by the accumulating circuit;

receiving the accumulated signal and the respective pulses by a processor (112);
generating first data representative of the accumulated signal and second data representative of the respective pulses by the processor (112); and
processing the first and second data in accordance with at least one algorithm by the processor (112), thereby determining whether the at least one potential arcing event is indicative of an arc fault or a nuisance condition.

18. The method of claim 17 further including the steps of monitoring the power input by a current sensor (TR1), and providing the signal associated with the power input to the input sense circuit (102) by the current sensor.

19. The method of claim 18 wherein the current sensor comprises a transformer (TR1) having a primary coil and a secondary coil, the secondary coil being weakly coupled to the input sense circuit (102).

20. The method of claim 17 further including the step of tripping an electromechanical interface (117) coupled between the power input and a power output if the at least one potential arcing event is indicative of an arc fault, thereby disconnecting the power output from a load coupleable thereto.

21. The method of claim 20 wherein the electromechanical interface comprises a solenoid (118).

22. The method of claim 17 wherein the amplifying circuit comprises a comparator (105a).

23. The method of claim 17 wherein the accumulating circuit comprises an integrating capacitor (C3).

24. The method of claim 17 wherein the accumulating circuit comprises a digital counter.

25. The method of claim 17 wherein the amplifying circuit comprises a plurality of comparators (121,123), and further including the steps of generating a respective pulse by a respective one of the comparators in the event the sensed signal exceeds a respective predetermined threshold, receiving the respective pulses generated by the plurality of comparators by the processor, and incrementing a digital counter at different rates based on the received pulses by the processor.

26. The method of claim 17 further including the steps of measuring the accumulated signal a number of times over a set of cycles by the processor (112), generating the first data representative of the accumulated signal measurements by the processor, and processing the first data in accordance with an algorithm including the sub-steps of calculating a first measurement associated with a first cycle minus a second measurement associated with a second cycle to obtain a first calculated value, calculating a third measurement associated with a third cycle minus the second measurement associated with the second cycle to obtain a second calculated value, calculating the third measurement associated with the third cycle minus the first measurement associated with the first cycle to obtain a third calculated value, taking the absolute values of the first, second, and third calculated values, and calculating the first value plus the second value minus the third value to obtain a fourth calculated value.

27. The method of claim 26 further including the steps of repeating the processing of the first data in accordance with the algorithm using signal measurements corresponding to at least one different set of cycles, and maintaining a running sum of the fourth calculated values, the running sum being representative of the total amount of electrical arcing occurring during the predetermined time period.

28. The method of claim 27 further including the step of processing the second data in accordance with at least one second algorithm to count the number of arcing events included in the running sum.

29. The method of claim 17 further including the step of processing the second data in accordance with an algorithm for counting the number of arcing events occurring during the predetermined time period by the processor.

30. The method of claim 29 further including the step of capturing timing information relating to the arcing events.

**Patentansprüche**

1. Vorrichtung (100) zur Erkennung von Kurzschlusslichtbögen, mit:

einem Leistungseingang,

einer Eingangserfassungsschaltung (102), die derart eingerichtet ist, dass sie ein Signal abgreift, das dem Leistungseingang zugeordnet ist, wobei das abgegriffene Signal auf wenigstens ein potentielles Lichtbogenüberschlagereignis hinweist, und

einer Lichtbogenerfassungsschaltung (104), die eine verstärkende Unterschaltung (116) und eine zusammenfassende Unterschaltung (D7, R7, C3) aufweist, wobei die verstärkende Unterschaltung derart eingerichtet ist, dass sie eine Darstellung des abgegriffenen Signals empfängt und einen entsprechenden Impuls, entsprechend dem wenigstens einen potentiellen Lichtbogenüberschlagereignis, erzeugt, wobei die zusammenfassende Unterschaltung derart eingerichtet ist, dass sie entsprechende, von der verstärkenden Unterschaltung erzeugte Impulse empfängt und ein zusammengefasstes Signal über ein vorbestimmtes Zeitintervall generiert,

einem Prozessor (112), der so betrieben wird, dass er das zusammengefasste Signal von der Lichtbogenerfassungsschaltung empfängt, erste das zusammengefasste Signal darstellende Daten erzeugt und die ersten Daten gemäß wenigstens einem Algorithmus verarbeitet, um festzustellen, ob das wenigstens eine potentielle Lichtbogenüberschlagereignis auf einen Kurzschlusslichtbogen oder einen Störzustand hinweist,

**dadurch gekennzeichnet, dass** der Prozessor (112) ferner so betrieben wird, dass er die entsprechenden Impulse von der Lichtbogenerfassungsschaltung (104) empfängt, zweite die entsprechenden Impulse darstellende Daten erzeugt und die zweiten Daten gemäß wenigstens einem Algorithmus verarbeitet, um festzustellen, ob das wenigstens eine potentielle Lichtbogenüberschlagereignis auf einen Kurzschlusslichtbogen oder einen Störzustand hinweist.

2. Vorrichtung nach Anspruch 1, die ferner einen Stromfühler (TR1) aufweist, der derart eingerichtet ist, dass er den Leistungseingang überwacht und das Signal, das dem Leistungseingang zugeordnet ist, der Eingangserfassungsschaltung (102) zuführt.

3. Vorrichtung nach Anspruch 2, bei der der Stromfühler einen Transformator (TR1) umfasst, der eine Primärspule und eine Sekundärspule aufweist, wobei die Sekundärspule schwach mit der Eingangserfassungsschaltung (102) gekoppelt ist.

4. Vorrichtung nach Anspruch 1, die ferner einen Leistungsausgang und eine elektromechanische Schnittstelle (117) aufweist, die zwischen den Leistungseingang und den Leistungsausgang gekoppelt ist, wobei der Prozessor (112) ferner so betrieben wird, dass er, wenn das wenigstens eine potentielle Lichtbogenüberschlagereignis auf einen Kurzschlusslichtbogen hinweist, die elektromechanische Schnittstelle auslöst, wodurch der Leistungsausgang von einer damit koppelbaren Last getrennt wird.

5. Vorrichtung nach Anspruch 4, bei der die elektromechanische Schnittstelle eine Zylinderspule (118) aufweist.

6. Vorrichtung nach Anspruch 1, bei der die verstärkende Unterschaltung eine Vergleichsunterschaltung (105a) aufweist.

7. Vorrichtung nach Anspruch 1, bei der die zusammenfassende Unterschaltung einen integrierenden Kondensator (C3) aufweist.

8. Vorrichtung nach Anspruch 1, bei der die zusammenfassende Unterschaltung einen digitalen Zähler aufweist.

9. Vorrichtung nach Anspruch 1, bei der die verstärkende Unterschaltung (105b) mehrere Komparatoren (121, 123) aufweist, wobei jeder Komparator derart eingerichtet ist, dass er einen entsprechenden Impuls erzeugt, falls das abgegriffene Signal einen entsprechenden vorbestimmten Schwellwert überschreitet, wobei die zusammenfassende Schaltung einen digitalen Zähler aufweist und wobei der Prozessor so betrieben wird, dass er die entsprechenden Impulse, die von den mehreren Komparatoren erzeugt werden, empfängt und den digitalen Zähler mit unterschiedlichen Raten, beruhend auf den empfangenen Impulsen, erhöht.

10. Vorrichtung nach Anspruch 1, bei der der Prozessor (112) so betrieben wird, dass er das zusammengefasste Signal mehrmals über einen Satz von Perioden misst, die ersten Daten erzeugt, die die Messungen des ersten zusammengefassten Signals darstellen, und die ersten Daten gemäß einem Algorithmus verarbeitet, der das Rechnen einer ersten Messung, die einer ersten Periode zugeordnet ist, minus einer zweiten Messung, die einer zweiten Periode zugeordnet ist, um einen ersten errechneten Wert zu erhalten, das Rechnen einer dritten Messung, die einer dritten Periode zugeordnet ist, minus der zweiten Messung, die der zweiten Periode zugeordnet ist, um einen

14

zweiten errechneten Wert zu erhalten, das Rechnen der dritten Messung, die der dritten Periode zugeordnet ist, minus der ersten Messung, die der ersten Periode zugeordnet ist, um einen dritten errechneten Wert zu erhalten, das Nehmen des Betrags des ersten, des zweiten und des dritten errechneten Wertes und das Rechnen des ersten Wertes plus des zweiten Wertes minus des dritten Wertes, um einen vierten errechneten Wert zu erhalten, beinhaltet.

11. Vorrichtung nach Anspruch 10, bei der der Prozessor (112) ferner so betrieben wird, dass er die Verarbeitung der ersten Daten gemäß dem Algorithmus unter Verwendung von Signalmessungen, die wenigstens einem unterschiedlichen Satz von Perioden entsprechen, wiederholt und eine laufende Summe des vierten errechneten Wertes führt, wobei die laufende Summe eine Darstellung des Gesamtbetrags an elektrischer Lichtbogenbildung ist, die während des vorbestimmten Zeitintervalls auftritt.

12. Vorrichtung nach Anspruch 11, bei der der Prozessor ferner so betrieben wird, dass er die zweiten Daten gemäß wenigstens einem zweiten Algorithmus verarbeitet, um die Anzahl der Lichtbogenüberschlagereignisse, die in der laufenden Summe enthalten sind, zu zählen.

13. Vorrichtung nach Anspruch 1, bei der der Prozessor (112) so betrieben wird, dass er die zweiten Daten gemäß einem Algorithmus zum Zählen der Anzahl der Lichtbogenüberschlagereignisse, die während des vorbestimmten Zeitintervalls auftreten, verarbeitet.

14. Vorrichtung nach Anspruch 13, bei der der Prozessor ferner so betrieben wird, dass er Zeitinformationen, die die Lichtbogenüberschlagereignisse betreffen, erfasst.

15. Vorrichtung nach Anspruch 1, bei der das abgegriffene Signal ein Wechselstromsignal ist.

16. Vorrichtung nach Anspruch 1, bei der das abgegriffene Signal ein Gleichstromsignal ist.

17. Verfahren zur Erkennung von Kurzschlusslichtbögen, mit den folgenden Schritten:

Abgreifen eines Signals, das einem Leistungseingang zugeordnet ist, mittels einer Eingangserfassungsschaltung (102), wobei das abgegriffene Signal auf wenigstens ein potentielles Lichtbogenüberschlagereignis hinweist,
Empfangen einer Darstellung des abgegriffenen Signals mittels einer verstärkenden Schaltung (116),
Erzeugen eines entsprechenden Impulses, entsprechend dem wenigstens einen potentiellen Lichtbogenüberschlagereignis durch die verstärkende Schaltung,
Empfangen der entsprechenden Impulse durch eine zusammenfassende Schaltung (D7, R7, C3) und
Erzeugen eines zusammengefassten Signals über ein vorbestimmtes Zeitintervall durch die zusammenfassende Schaltung,
Empfangen des zusammengefassten Signals und der entsprechenden Impulse durch einen Prozessor (112),
Erzeugen erster das zusammengefasste Signal darstellender Daten und zweiter die entsprechenden Impulse darstellender Daten durch den Prozessor (112) und
Verarbeiten der ersten und der zweiten Daten gemäß wenigstens einem Algorithmus durch den Prozessor (112), wodurch festgestellt wird, ob das wenigstens eine potentielle Lichtbogenüberschlagereignis auf einen Kurzschlusslichtbogen oder einen Störzustand hinweist.

18. Verfahren nach Anspruch 17, das ferner die Schritte der Überwachung des Leistungseingangs durch einen Stromfühler (TR1) und die Zuführung des Signals, das dem Leistungseingang zugeordnet ist, zu der Eingangserfassungsschaltung (102) durch den Stromfühler aufweist.

19. Verfahren nach Anspruch 18, bei dem der Stromfühler einen Transformator (TR1) umfasst, der eine Primärspule und eine Sekundärspule aufweist, wobei die Sekundärspule schwach mit der Eingangserfassungsschaltung (102) gekoppelt ist.

20. Verfahren nach Anspruch 17, ferner mit dem Schritt des Auslösens einer elektromechanischen Schnittstelle (117), die zwischen den Leistungseingang und einen Leistungsausgang gekoppelt ist, wenn das wenigstens eine potentielle Lichtbogenüberschlagereignis auf einen Kurzschlusslichtbogen hinweist, wodurch der Leistungsausgang von einer damit koppelbaren Last getrennt wird.

21. Verfahren nach Anspruch 20, bei dem die elektromechanische Schnittstelle eine Zylinderspule (118) aufweist.

**22.** Verfahren nach Anspruch 17, bei dem die verstärkende Schaltung einen Komparator (105a) aufweist.

**23.** Verfahren nach Anspruch 17, bei dem die zusammenfassende Schaltung einen integrierenden Kondensator (C3) aufweist.

**24.** Verfahren nach Anspruch 17, bei dem die zusammenfassende Schaltung einen digitalen Zähler aufweist.

**25.** Verfahren nach Anspruch 17, bei dem die verstärkende Schaltung mehrere Komparatoren (121, 123) umfasst, und das ferner die Schritte des Erzeugens eines entsprechenden Impulses durch einen entsprechenden der Komparatoren in dem Fall, dass das abgegriffene Signal einen entsprechenden vorbestimmten Schwellwert überschreitet, des Empfangens der entsprechenden, von den mehreren Komparatoren erzeugten Impulse durch den Prozessor und des Erhöhens eines digitalen Zählers mit unterschiedlichen Raten, beruhend auf den empfangenen Impulsen, durch den Prozessor aufweist.

**26.** Verfahren nach Anspruch 17, das ferner die Schritte des mehrmaligen Messens des zusammengefassten Signals über einen Satz von Perioden durch den Prozessor (112), des Erzeugens der ersten Daten, die die Messungen des zusammengefassten Signals darstellen, durch den Prozessor und des Verarbeitens der ersten Daten gemäß einem Algorithmus aufweist, der die Teilschritte des Rechnens einer ersten Messung, die einer ersten Periode zugeordnet ist, minus einer zweiten Messung, die einer zweiten Periode zugeordnet ist, um einen ersten errechneten Wert zu erhalten, des Rechnens einer dritten Messung, die einer dritten Periode zugeordnet ist, minus der zweiten Messung, die der zweiten Periode zugeordnet ist, um einen zweiten errechneten Wert zu erhalten, des Rechnens der dritten Messung, die der dritten Periode zugeordnet ist, minus der ersten Messung, die der ersten Periode zugeordnet ist, um einen dritten errechneten Wert zu erhalten, des Nehmens des Betrags des ersten, des zweiten und des dritten berechneten Wertes und des Rechnens des ersten Wertes plus des zweiten Wertes minus des dritten Wertes, um einen vierten errechneten Wert zu erhalten, beinhaltet.

**27.** Verfahren nach Anspruch 26, das ferner die Schritte des Wiederholens des Verarbeitens der ersten Daten gemäß dem Algorithmus unter Verwendung von Signalmessungen, die wenigstens einem unterschiedlichen Satz von Perioden entsprechen, und des Führens einer laufenden Summe des vierten errechneten Wertes aufweist, wobei die laufende Summe eine Darstellung des Gesamtbetrags an elektrischer Lichtbogenbildung ist, die während des vorbestimmten Zeitintervalls auftritt.

**28.** Verfahren nach Anspruch 27, das ferner den Schritt der Verarbeitung der zweiten Daten gemäß wenigstens einem zweiten Algorithmus aufweist, um die Anzahl der Lichtbogenüberschlagereignisse, die in der laufenden Summe enthalten sind, zu zählen.

**29.** Verfahren nach Anspruch 17, das ferner den Schritt der Verarbeitung der zweiten Daten durch den Prozessor gemäß einem Algorithmus zum Zählen der Anzahl der Lichtbogenüberschlagereignisse, die während des vorbestimmten Zeitintervalls auftreten, aufweist.

**30.** Verfahren nach Anspruch 29, das ferner den Schritt des Erfassens von Zeitinformationen, die die Lichtbogenüberschlagereignisse betreffen, aufweist.

**Revendications**

**1.** Appareil de détection de défauts d'arc (100) comprenant :

une entrée de puissance ;
un circuit de détection d'entrée (102) configuré pour détecter un signal associé à l'entrée de puissance, le signal détecté étant indicatif d'un événement de formation d'arc potentiel au moins ; et
un circuit de détection de formation d'arc (104) comprenant un circuit secondaire d'amplification (116) et un circuit secondaire d'accumulation (D7, R7, C3), le circuit secondaire d'amplification étant configuré pour recevoir une représentation du signal détecté et générer une impulsion respective qui correspond à le au moins un événement de formation d'arc potentiel, le circuit secondaire d'accumulation étant configuré pour recevoir les impulsions respectives générées par le circuit secondaire d'amplification et générer un signal accumulé sur une période de temps prédéterminée ; et
un processeur (112) capable de recevoir le signal accumulé en provenance du circuit de détection de formation d'arc, de générer des premières données représentatives du signal accumulé et de traiter les premières données selon au moins un algorithme, afin de déterminer si le au moins un événement de formation d'arc potentiel est indicatif d'un défaut d'arc ou d'un état de perturbation ;

**caractérisé en ce que** le processeur (112) est en outre capable de recevoir les impulsions respectives en provenance du circuit de détection de formation d'arc (104), de générer des secondes données représentatives des impulsions respectives et de traiter les secondes données selon au moins un algorithme, afin de déterminer si le au moins un événement de formation d'arc potentiel est indicatif d'un défaut d'arc ou d'un état de perturbation.

2. Appareil selon la revendication 1, comprenant en outre un capteur de courant (TR1) configuré pour surveiller l'entrée de puissance et fournir le signal associé à l'entrée de puissance au circuit de détection d'entrée (102).

3. Appareil selon la revendication 2, dans lequel le capteur de courant comprend un transformateur (TR1) présentant un enroulement primaire et un enroulement secondaire, l'enroulement secondaire étant faiblement couplé au circuit de détection d'entrée (102).

4. Appareil selon la revendication 1, comprenant en outre une sortie de puissance et une interface électromécanique (117) couplée entre l'entrée de puissance et la sortie de puissance, dans lequel le processeur (112) est en outre capable de déclencher l'interface électromécanique si le au moins un événement de formation d'arc potentiel est indicatif d'un défaut d'arc, en déconnectant de ce fait la sortie de puissance d'une charge pouvant y être couplée.

5. Appareil selon la revendication 4, dans lequel l'interface électromécanique comprend un solénoïde (118).

6. Appareil selon la revendication 1, dans lequel le circuit secondaire d'amplification comprend un circuit secondaire de comparaison (105a).

7. Appareil selon la revendication 1, dans lequel le circuit secondaire d'accumulation comprend un condensateur d'intégration (C3).

8. Appareil selon la revendication 1, dans lequel le circuit secondaire d'accumulation comprend un compteur numérique,

9. Appareil selon la revendication 1, dans lequel le circuit secondaire d'amplification (105b) comprend une pluralité de comparateurs (121, 123), chaque comparateur étant configuré pour générer une impulsion respective dans le cas où le signal détecté dépasse un seuil prédéterminé respectif, dans lequel le circuit d'accumulation comprend un compteur numérique, et dans lequel le processeur est capable de recevoir les impulsions respectives générées par la pluralité de comparateurs, et d'incrémenter le compteur numérique à différentes vitesses sur la base des impulsions reçues.

10. Appareil selon la revendication 1, dans lequel le processeur (112) est capable de mesurer le signal accumulé un certain nombre de fois sur un ensemble de cycles, de générer les premières données représentatives des mesures du signal accumulé et de traiter les premières données selon un algorithme qui comprend les étapes consistant à calculer une première mesure associée à un premier cycle moins une deuxième mesure associée à un deuxième cycle pour obtenir une première valeur calculée, à calculer une troisième mesure associée à un troisième cycle moins la deuxième mesure associée au deuxième cycle pour obtenir une deuxième valeur calculée, à calculer la troisième mesure associée au troisième cycle moins la première mesure associée au premier cycle pour obtenir une troisième valeur calculée, à prendre les valeurs absolues des première, deuxième et troisième valeurs calculées, et à calculer la première valeur plus la deuxième valeur moins la troisième valeur pour obtenir une quatrième valeur calculée.

11. Appareil selon la revendication 10, dans lequel le processeur (112) est en outre capable de répéter le traitement des premières données selon l'algorithme en utilisant des mesures de signal qui correspondent au moins à un ensemble différent de cycles, et de maintenir une somme cumulée des quatrièmes valeurs calculées, la somme cumulée étant représentative de la quantité totale de formations d'arcs électriques qui se produisent au cours de la période de temps prédéterminée.

12. Appareil selon la revendication 11, dans lequel le processeur (112) est en outre capable de traiter les deuxièmes données selon au moins un deuxième algorithme afin de compter le nombre d'événements de formation d'arc inclus dans la somme cumulée.

**13.** Appareil selon la revendication 1, dans lequel le processeur (112) est capable de traiter les deuxièmes données selon un algorithme destiné à compter le nombre d'événements de formation d'arc qui se produisent au cours de la période de temps prédéterminée.

**14.** Appareil selon la revendication 13, dans lequel le processeur (112) est en outre capable de capturer des informations de synchronisation qui se rapportent aux événements de formation d'arc.

**15.** Appareil selon la revendication 1, dans lequel le signal détecté est un signal en courant alternatif.

**16.** Appareil selon la revendication 1, dans lequel le signal détecté est un signal en courant continu.

**17.** Procédé destiné à détecter des défauts d'arcs, comprenant les étapes consistant à :

détecter un signal associé à une entrée de puissance à l'aide d'un circuit de détection d'entrée (102), le signal détecté étant indicatif d'un événement de formation d'arc potentiel au moins ;
recevoir une représentation du signal détecté à l'aide d'un circuit d'amplification (116) ;
générer une impulsion respective qui correspond à le au moins un événement de formation d'arc potentiel à l'aide du circuit d'amplification ;
recevoir les impulsions respectives à l'aide d'un circuit d'accumulation (D7, R7, C3) ; et
générer un signal accumulé sur une période de temps prédéterminée à l'aide du circuit d'accumulation ;
recevoir le signal accumulé et les impulsions respectives à l'aide d'un processeur (112) ;
générer des premières données représentatives du signal accumulé et des deuxièmes données représentatives des impulsions respectives à l'aide du processeur (112) ; et
traiter les premières et les deuxièmes données selon au moins un algorithme à l'aide du processeur (112), en déterminant de ce fait si le au moins un événement de formation d'arc potentiel est indicatif d'un défaut d'arc ou d'un état de perturbation.

**18.** Procédé selon la revendication 17, comprenant en outre les étapes consistant à surveiller l'entrée de puissance à l'aide d'un capteur de courant (TR1), et à fournir le signal associé à l'entrée de puissance au circuit de détection d'entrée (102) à l'aide du capteur de courant.

**19.** Procédé selon la revendication 18, dans lequel le capteur de courant comprend un transformateur (TR1) présentant un enroulement primaire et un enroulement secondaire, l'enroulement secondaire étant faiblement couplé au circuit de détection d'entrée (102).

**20.** Procédé selon la revendication 17, comprenant en outre l'étape consistant à déclencher une interface électromécanique (117) couplée entre l'entrée de puissance et une sortie de puissance si le au moins un événement de formation d'arc potentiel est indicatif d'un défaut d'arc, en déconnectant de ce fait la sortie de puissance d'une charge pouvant y être couplée.

**21.** Procédé selon la revendication 20, dans lequel l'interface électromécanique comprend un solénoïde (118).

**22.** Procédé selon la revendication 17, dans lequel le circuit d'amplification comprend un comparateur (105a).

**23.** Procédé selon la revendication 17, dans lequel le circuit d'accumulation comprend un condensateur d'intégration (C3).

**24.** Procédé selon la revendication 17, dans lequel le circuit d'accumulation comprend un compteur numérique.

**25.** Procédé selon la revendication 17, dans lequel le circuit d'amplification comprend une pluralité de comparateurs (121, 123), et comprenant en outre les étapes consistant à générer une impulsion respective à l'aide de l'un respectif des comparateurs dans le cas où le signal détecté dépasse un seuil prédéterminé respectif, à recevoir les impulsions respectives générées par la pluralité de comparateurs à l'aide du processeur, et à incrémenter un compteur numérique à différentes vitesses sur la base des impulsions reçues par le processeur.

**26.** Procédé selon la revendication 17, comprenant en outre les étapes consistant à mesurer le signal accumulé un certain nombre de fois sur un ensemble de cycles à l'aide du processeur (112), à générer les premières données représentatives des mesures du signal accumulé à l'aide du processeur (112), et à traiter les premières données selon un algorithme qui comprend les étapes secondaires consistant à calculer une première mesure associée à un premier cycle moins une deuxième mesure associée à un deuxième cycle pour obtenir une première valeur calculée, à calculer une troisième mesure associée à un troisième cycle moins la deuxième mesure associée au deuxième cycle pour obtenir une deuxième valeur calculée, à calculer la troisième mesure associée au troisième cycle moins la première mesure associée au premier cycle pour obtenir une troisième valeur calculée, à prendre les valeurs absolues des première, deuxième et troisième valeurs calculées, et à calculer la première valeur plus la deuxième valeur moins la troisième valeur pour obtenir une quatrième valeur calculée.

**27.** Procédé selon la revendication 26, comprenant en outre les étapes consistant à répéter le traitement des premières données selon l'algorithme en utilisant des mesures de signal qui correspondent au moins à un ensemble différent de cycles, et à maintenir une somme cumulée des quatrièmes valeurs calculées, la somme cumulée étant représentative de la quantité totale de formations d'arcs électriques qui se produisent au cours de la période de temps prédéterminée.

**28.** Procédé selon la revendication 27, comprenant en outre l'étape consistant à traiter les deuxièmes données selon au moins un deuxième algorithme afin de compter le nombre d'événements de formation d'arc inclus dans la somme cumulée.

**29.** Procédé selon la revendication 17, comprenant en outre l'étape consistant à traiter les deuxièmes données selon un algorithme destiné à compter le nombre d'événements de formation d'arc qui se produisent au cours de la période de temps prédéterminée à l'aide du processeur.

**30.** Procédé selon la revendication 29, comprenant en outre l'étape consistant à capturer des informations de synchronisation qui se rapportent aux événements de formation d'arc.

*Fig. 1a*

EP 1 638 181 B1

*Fig. 1b*

EP 1 638 181 B1

TR2 TR3

A

C

214

202

212

**Fig. 2a**

TR2

TR3

212

202

**Fig. 2b**

EP 1 638 181 B1

Fig. 2c

Fig. 2d

23

102a

Q

C1 · · L2 · R23 · R24 · D14 · D15 · T1 · T2 · C12 · C13 · R25 · R26 · T3 · T4 · C2

**Fig. 3a**

105a

NODE 114 · vcc · vcc · R32 · D7 · C3 · 120 · vcc · R30 · R31

**Fig. 3c**

Fig. 3b

*Fig. 3d*

A → Reset integrating capacitor, initialize flags **402**

**406** Line voltage > samp_hi? — Yes → (to 409)

No ↓

Wait **407** → (back to 406)

Wait **408**

**409** Line voltage < sample1? — No → (back to Wait 408)

Yes ↓

Measure integrating capacitor voltage, reset capacitor **414**

**416** Is push-button actuated? — No → (to 434 path)

Yes ↓

Inject arc-like noise into capacitor **420**

Enter voltage measurement into stack **434**

Execute three cycle algorithm (TCA) **440**

Maintain running sum of TCA calculations **444**

**446** Running sum > max_limit? — No → A

Yes ↓

Fire SCR to disconnect Power Output **448**

↓ A

*Fig. 4*

27

Start

Search for data elements in
measurement data set
having same first value k
502

Analyze measurement data set to
determine data elements having
value 0, first data value k, and
second data value j
504

Map measurement data set
506

Mapped
data set match
one of predetermined
data sets indicative of
periodicity?
508

No

Yes

Inhibit tripping
510

End

*Fig. 5a*

Start

Track amount of time
required for arcing event to
occur within sampling period
514

Store measured time values over
multiple sampling periods to
provide history of arcing event
times
516

Analyze history to
determine randomness of
arcing event times
518

Arcing event(s)
occur at same time
during each sampling
period?
520

No

Yes

Inhibit tripping
522

End

*Fig. 5b*

| | Oldest Data | | | Newest Data | Pulse Counter Active? |
|---|---|---|---|---|---|
| 0x0 | 0 | 0 | 0 | 0 | Y |
| 0x1 | 0 | 0 | 0 | k | N |
| 0x2 | 0 | 0 | k | 0 | N |
| 0x3 | 0 | 0 | k | k | Y |
| 0x4 | 0 | k | 0 | 0 | N |
| 0x5 | 0 | k | 0 | k | Y |
| 0x6 | 0 | k | k | 0 | N |
| 0x7 | 0 | k | k | k | Y |
| 0x8 | k | 0 | 0 | 0 | Y |
| 0x9 | k | 0 | 0 | k | N |
| 0xA | k | 0 | k | 0 | Y |
| 0xB | k | 0 | k | k | N |
| 0xC | k | k | 0 | 0 | Y |
| 0xD | k | k | 0 | k | N |
| 0xE | k | k | k | 0 | Y |
| 0xF | k | k | k | k | Y |

ANY OTHER COMBINATIONS: PULSE COUNTER = N
e.g. [0 0 j k]

Legend:

0 = Zero Pulses during AC half-cycle
k = a "k" number of pulses during AC half-cycle
j = a "j" number of pulses different from "k" in AC half-cycle
Y = Pulse Counter Active
N = Pulse Counter Inactive

*Fig. 6*

Start

Take
measurement
702

Increment event
counter 1
706 ← Yes — Measurement >
threshold 1?
704

No

Increment event
counter 2
710 ← Yes — Measurement >
threshold 2?
708

No

Process measurement
through algorithms
712

No — Running sum 1 >
trip threshold 1?
714

Running sum 2 >
trip threshold 2?
718 — No

Yes

Yes

No — Event counter 1 >
min. events 1?
716

Event counter 2 >
min. events 2?
720 — No

Yes

Yes

Trip
device
722

End

*Fig. 7*

*Fig. 8*

*Fig. 9*

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20040095695 A1
- EP 1429437 A1
- US 6532424 B1
- US 2004066593 A1

**Non-patent literature cited in the description**

- **BENNER C L et al.** Practical High-Impedance Fault Detection On Distribution Feeders. *IEEE Transactions On Industry Applications,* May 1997, vol. 33 (3), 635-640